# EUROPEAN PATENT APPLICATION

(11) **EP 4 742 859 A1**
(43) Date of publication of application: **13.05.2026**
(21) Application number: 25201837.9
(22) Date of filing: 12.09.2025
(51) Int. Cl.: H10F 10/16, H10F 10/161, H10F 77/12, H10F 77/16, H10F 77/20

(54) **LAMINATED BODY, SOLAR CELL, MULTI-JUNCTION SOLAR CELL, SOLAR CELL MODULE, AND MANUFACTURING METHOD FOR LAMINATED BODY**

(30) Priority: 08.11.2024 JP 2024195997
(71) Applicant: KABUSHIKI KAISHA TOSHIBA, Kawasaki-shi, Kanagawa, 212-0013 (JP)
(72) Inventor: HONISHI, Yuya, Kawasaki-shi, Kanagawa (JP); SHIBASAKI, Soichiro, Kawasaki-shi, Kanagawa (JP); NAKAGAWA, Naoyuki, Kawasaki-shi, Kanagawa (JP); YAMAMOTO, Kazushige, Kawasaki-shi, Kanagawa (JP)
(74) Representative: Hoffmann Eitle

(57) **Abstract**

A laminated body according to an embodiment includes a transparent substrate, a p-electrode on the substrate, including a transparent conductive oxide film, and a p-type light-absorbing layer on the p-electrode, including a cuprous oxide compound. A crystal grain size of the cuprous oxide compound is 1.2 times or more a thickness of the p-type light-absorbing layer. A carrier concentration of the p-type light-absorbing layer is 5.0×10¹⁴ [cm⁻³] or more. The cuprous oxide compound comprises Cu, oxygen, and optionally an element represented by M1. The element represented by M1 is one or more elements selected from the group consisting of Li, Na, K, Al, Ga, In, C, Si, Ge, Sn, N, P, Sb, and Bi.

## Description

### FIELD

Embodiments described herein relate generally to a laminated body, an electronic device, a solar cell, a multi-junction solar cell, a solar cell module, a photovoltaic power generation system, and a manufacturing method for a laminated body.

### BACKGROUND

One of new solar cells is a solar cell using a cuprous oxide (Cu₂O) for a light-absorbing layer. Cu₂O is a wide-gap semiconductor. Since Cu₂O is a safe and inexpensive material including copper which presents abundantly on the earth and oxygen, it is expected that a low-cost solar cell with high-efficiency can be realized.

### BRIEF DESCRIPTION OF THE DRAWINGS

FIG. 1 is a schematic cross-sectional diagram of a laminated body according to an embodiment;
FIG. 2 shows analysis spots of a laminated body according to an embodiment;
FIG. 3 is a schematic diagram of a surface of a p-type light-absorbing layer according to an embodiment;
FIG. 4 is a flowchart of a manufacturing method of a laminated body according to an embodiment;
FIG. 5 is a schematic diagram of a manufacturing apparatus according to an embodiment;
FIG. 6 is a schematic cross-sectional diagram of a solar cell according to an embodiment;
FIG. 7 is a schematic cross-sectional diagram of a multi-junction solar cell according to an embodiment;
FIG. 8 is a perspective diagram of a solar cell module according to an embodiment;
FIG. 9 is a schematic cross-sectional diagram of a solar cell module according to an embodiment;
FIG. 10 is a configuration diagram of a photovoltaic power generation system according to an embodiment;
FIG. 11 is a conceptual diagram of a vehicle according to an embodiment;
FIG. 12 is a schematic diagram of a drone according to an embodiment;
FIG. 13 is a table relating to examples;
FIG. 14 is a table relating to examples;
FIG. 15 is a cross-sectional SEM image of a laminated body of an example; and
FIG. 16 is a table relating to examples.

### DETAILED DESCRIPTION

A laminated body according to an embodiment includes a transparent substrate, a p-electrode on the substrate, including a transparent conductive oxide film, and a p-type light-absorbing layer on the p-electrode, including a cuprous oxide compound. A crystal grain size of the cuprous oxide compound is 1.2 times or more a thickness of the p-type light-absorbing layer. A carrier concentration of the p-type light-absorbing layer is 5.0×10¹⁴ [cm⁻³] or more. The cuprous oxide compound comprises Cu, oxygen, and optionally an element represented by M1. The element represented by M1 is one or more elements selected from the group consisting of Li, Na, K, Al, Ga, In, C, Si, Ge, Sn, N, P, Sb, and Bi.

Hereinafter, an embodiment will be described in detail with reference to the drawings. Unless otherwise specified, values at 25[°C] and 1 atm (atmosphere) are described. An average represents an arithmetic mean value. Each concentration is an average concentration in the region or layer of interest. In each layer, the presence of a specific element is, for example, an element whose presence can be confirmed by SIMS (Secondary Ion Mass Spectrometry), and the absence of a specific element is, for example, an element whose presence cannot be confirmed by SIMS.

In the specification, "/" (slash) represents the division sign excluding "/" of "and/or" representing "or". In the specification, "·" (middle dot, dot operator) and "×" represent a multiplication sign. In the specification, "." (period) of a numerical value represents a decimal point.

The thickness and structure of members described in the specification can be known, for example, from one or more of images obtained by SEM (Scanning Electron Microscope), TEM (Transmission Electron Microscope), HAADF-STEM: High-Angle Annular Dark Field Scanning Transmission Electron Microscopy), and the like. The boundaries of the members described in the specification can be determined from one or more images obtained by scanning electron microscopy or transmission electron microscopy, SEM-EDS (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEP, PL (Photoluminescence), XPS (X-ray Photoelectron Spectroscopy), or the like. These analysis methods are examples and do not negate the specific analytical methods described in the specification.

### (FIRST EMBODIMENT)

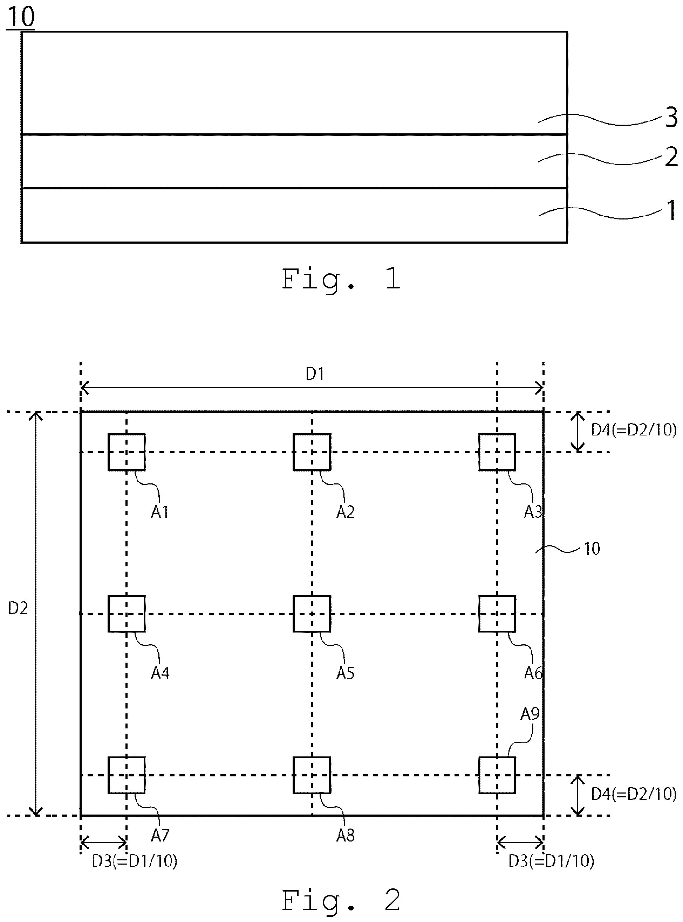

A first embodiment relates to a laminated body. FIG. 1 shows a schematic diagram of a laminated body 10. The laminated body 10 shown in FIG. 1 includes a substrate 1, a p-electrode, and a p-type light-absorbing layer 3. A member with the p-electrode 2 provided on the substrate 1 is used as a base member. The laminated body 10 is suitable for use as a solar cell.

The substrate 1 is a substrate that transmits infrared light to visible light. As the substrate 1, inorganic substrates such as physically strengthened glass, chemically strengthened glass (for example, borosilicate glass), crystallized glass (for example, NeoCeram, trademark), or quartz glass can be used.

The thickness of the substrate 1 is preferably 10 [µm] or more and 5 [mm] or less, for example. The thickness of the substrate 1 is measured as follows. First, the substrate 1 is measured with a scale. When the thickness of the substrate 1 can be measured in mm units (for example, when the thickness of the base member is 1 mm or more), the thickness is measured directly with a scale. When it cannot be measured in mm units, the thickness is determined by cross-sectional observation using an electron microscope or by a step meter.

It is preferable that the heat resistance temperature (service limit temperature) of the substrate 1 is equal to or higher than the temperature of the base member during sputtering of the p-type light-absorbing layer 3. When the temperature of the substrate 1 during sputtering of the p-type light-absorbing layer 3 approaches the heat resistance temperature, the heat resistance temperature of the substrate 1 may be lower than the temperature of the base member during sputtering of the p-type light-absorbing layer 3. The heat resistance temperature of the substrate 1 is not limited as long as no significant changes such as excessive deformation occur at a temperature relative to the sputtering temperature of the p-type light-absorbing layer 3.

It is preferable that the softening point [°C] of the substrate 1 is equal to or higher than the temperature of the base member during sputtering of the p-type light-absorbing layer 3.

The p-electrode 2 is provided on the substrate 1 and is disposed between the substrate 1 and the p-type light-absorbing layer 3. It is preferable that the p-electrode 2 forms an ohmic contact with the p-type light-absorbing layer 3. The p-electrode 2 is a conductive layer provided on the side of the p-type light-absorbing layer 3 and has light transmittance for wavelengths of about 1200 [nm] to visible light. The thickness of the p-electrode 2 is typically 50 [nm] or more and 2000 [nm] or less. In FIG. 1, the p-electrode 2 is in direct contact with the p-type light-absorbing layer 3. An intermediate layer not shown in the figure may be provided between the p-electrode 2 and the p-type light-absorbing layer 3.

The p-electrode 2 preferably includes an transparent conductive oxide film. It is preferable that the p-electrode 2 includes one or more layers of a transparent conductive oxide film. As the transparent conductive oxide film, Indium Tin Oxide (ITO), Aluminum-doped Zinc Oxide (AZO), Boron-doped Zinc Oxide (BZO), Gallium-doped Zinc Oxide (GZO), doped tin oxide, Titanium-doped Indium Oxide (ITiO), Indium Zinc Oxide (IZO), or Indium Gallium Zinc Oxide (IGZO), hydrogen-doped indium oxide (IHO), and other semiconductor conductive films can be used without particular limitation. The transparent conductive oxide film may be a laminated film having multiple films. As a dopant for a film such as tin oxide, one or more elements selected from the group consisting of In, Si, Ge, Ti, Cu, Sb, Nb, Ta, W, Mo, F and Cl can be used without particular limitation. The p-electrode preferably includes a tin oxide doped with one or more elements selected from the group consisting of In, Si, Ge, Ti, Cu, Sb, Nb, Ta, W, Mo, F and Cl. When heat resistance is considered, it is preferable to use an antimony-doped tin oxide film for the p-electrode 2. In the doped tin oxide film, one or more elements selected from the group consisting of In, Si, Ge, Ti, Cu, Sb, Nb, Ta, W, Mo, F, and Cl are preferably included in an amount of 10 atom% or less relative to the tin included in the tin oxide film.
The p-electrode 2 can use a laminated film comprising a transparent conductive oxide film and a metal film. The metal film preferably has a thickness of 1 [nm] or more and 500 [µm] or less, and the metal (including alloy) included in the metal film is not particularly limited to Mo, Au, Cu, Ag, Al, Ta, or W. The metal film is preferably a conductive layer with opening rather than a film without opening. Further, it is preferable that the p-electrode 2 includes electrodes (one or more selected from the group consisting of metals, alloys, graphene, conductive nitrides and conductive oxides) in a dot pattern, line pattern, or mesh pattern between the transparent conductive oxide film and the substrate 1, or between the transparent conductive oxide film and the p-type light-absorbing layer 3. It is preferable that the opening ratio is 50% or more for the metal in the dot pattern, line pattern or mesh pattern with respect to the transparent conductive oxide film. The metal in the dot, line or mesh pattern is not particularly limited to Mo, Au, Cu, Ag, Al, Ta or W. When a metal film is used for the p-electrode 2, it is preferable that the film thickness is about 5 [nm] or less from the viewpoint of light transmittance. When using a metal film in a line pattern or mesh pattern, since light transmittance is secured at the opening, there are no limitations on the film thickness of the metal film.

Preferably, a doped tin oxide film that forms an ohmic contact with the p-type light-absorbing layer 3 is provided on the surface of the p-type light-absorbing layer 3 side of the transparent conductive oxide film. It is preferable that at least a portion of the doped tin oxide film provided on the outer most surface of the p-type light-absorbing layer 3 side of the transparent conductive oxide film is in direct contact with the p-type light-absorbing layer 3.

The p-type light-absorbing layer 3 is a p-type semiconductor layer. The p-type light-absorbing layer 3 is provided on the p-electrode 2. The p-type light-absorbing layer 3 may be in direct contact with the p-electrode 2, or other layer(s) between thereof may exist as long as electrical contact with the p-electrode 2 can be secured. The p-electrode 2 is arranged between the substrate 1 and the p-type light-absorbing layer 3. The p-type light-absorbing layer 3 is mainly composed of a cuprous oxide compound. Preferably, the cuprous oxide compound has a cuprite structure.

The thickness of the p-type light-absorbing layer 3 is preferably 500 [nm] or more and 10 [µm] or less, and more preferably 750 [nm] or more and 7.0 [µm] or less.

The p-type light-absorbing layer 3 is preferably a semiconductor layer mainly composed of the cuprous oxide compound. It is preferable that the p-type light-absorbing layer 3 includes crystals of the cuprous oxide compound. It is preferable that the p-type light-absorbing layer 3 is polycrystalline cuprous oxide. The p-type light-absorbing layer 3 may contain a trace amount of one or more impurities selected from the group consisting of copper (Cu), copper oxide (CuO), and copper hydroxide (Cu(OH)₂) as impurities.

The cuprous oxide compound preferably includes copper, oxygen, and optionally an element represented by M1. The element represented by M1 is preferably one or more elements selected from the group consisting of Li, Na, K, Al, Ga, In, C, Si, Ge, Sn, N, P, Sb, and Bi, more preferably Si or/and N, and even more preferably N. The element represented by M1 preferably includes one or more elements selected from the group consisting of Li, Na, K, Al, Ga, In, C, Si, Ge, Sn, N, P, Sb, and Bi, and may further optionally include one or more elements selected from the group consisting of Cl, F, Br, I, Sn, Ag, Cs, Rb, Zn, Mg, B, Ti, Hf, Zr, and Ca. The element represented by M1 preferably includes at least Si or/and N, and may further optionally include one or more elements selected from the group consisting of Li, Na, K, Al, Ga, In, C, Ge, Sn, P, Sb, Bi, Cl, F, Br, I, Sn, Ag, Cs, Rb, Zn, Mg, B, Ti, Hf, Zr, and Ca. The element represented by M1 includes at least N, and may further optionally include one or more elements selected from the group consisting of Li, Na, K, Al, Ga, In, C, Si, Ge, Sn, P, Sb, Bi, Cl, F, Br, I, Sn, Ag, Cs, Rb, Zn, Mg, B, Ti, Hf, Zr, and Ca.

Due to carrier-doping of the cuprous oxide compound in the p-type light-absorbing layer 3 with one or more elements selected from the group consisting of Li, Na, K, Al, Ga, In, C, Si, Ge, Sn, N, P, Sb, and Bi, the carrier concentration of the p-type light-absorbing layer 3 is increased. N and/or Si are preferable as dopants for increasing the carrier concentration in the p-type light-absorbing layer 3. N is more preferable for increasing the carrier concentration.

When an atomic ratio of all elements other than oxygen is set to 100%, the total amount of copper elements and elements represented by M1 included in the p-type light-absorbing layer 3 is preferably 95% or more and 100% or less, more preferably 98% or more and 100% or less, and even more preferably 99% or more and 100% or less.

When an atomic ratio of the copper element included in the p-type light-absorbing layer 3 is set to 100%, the total amount of all elements other than oxygen is preferably 0.00001% or more and 0.1% or less, more preferably 0.00001% or more and 0.01% or less, and even more preferably 0.00001% or more and 0.001% or less. When this composition ratio is not satisfied, it may become difficult for the cuprous oxide compound to have a cuprite structure, the light transmittance of the p-type light-absorbing layer 3 may be reduced, and the band gap may fall outside the preferable range. It is preferable that the above composition ratio is satisfied in the entirety of the p-type light-absorbing layer 3. More preferably, the above range is satisfied at least in a region from the interface (starting point) between the p-type light-absorbing layer 3 and the p-electrode 2 to a depth (ending point) of 20% or more of the thickness of the p-type light-absorbing layer 3 towards an interface (surface) opposite to the p-electrode 2, or/and a region from the interface (starting point) to a depth (ending point) of 1 [µm] or more from the interface towards an interface (surface) opposite to the p-electrode 2.

When an atomic ratio of the copper element included in the p-type light-absorbing layer 3 is set to 100 [%], the total amount of the element represented by M1 included in the p-type light-absorbing layer 3 is preferably 0.00001 [%] or more and 1 [%] or less, more preferably 0.0001 [%] or more and 0.1 [%] or less, and even more preferably 0.0001 [%] or more and 0.01 [%] or less. When the above composition ratio is not satisfied, it may become difficult for the cuprous oxide compound to have a cuprite structure, the transmittance of the p-type light-absorbing layer 3 may decrease, or the band gap may be outside the preferable range. The upper limit of the above range is preferably satisfied by the entire p-type light-absorbing layer 3. The lower limit of the above range is preferably satisfied by the entire p-type light-absorbing layer 3. More preferably, the lower limit is satisfied at least in a region from the interface (starting point) between the p-type light-absorbing layer 3 and the p-electrode 2 to a depth (ending point) of 20% or more of the thickness of the p-type light-absorbing layer 3 towards an interface (surface) opposite to the p-electrode 2, or/and a region from the interface (starting point) to a depth (ending point) of 1 [µm] or more from the interface towards an interface (surface) opposite to the p-electrode 2.

The number of oxygen atoms included in the cuprous oxide compound is preferably 0.48 or more and 0.56 or less when the number of copper atoms is set to 1. When there is too much oxygen compared to copper, the ratio of copper oxide included in the cuprous oxide compound will increase, resulting in a narrower band gap and reduced transmittance of the p-type light-absorbing layer 3. When there is too little oxygen compared to copper, the amount of copper included in the cuprous oxide compound will increase, resulting in reduced transmittance. Moreover, when the ratio of oxygen to copper does not fall within the above range, it may become difficult for the cuprous oxide compound to have a cuprite structure.

It is preferable that 95 [wt%] or more and 100 [wt%] or less of the p-type light-absorbing layer 3 is composed of the cuprous oxide compound. More preferably, 98 [wt%] or more and 100 [wt%] or less of the p-type light-absorbing layer 3 is composed of the cuprous oxide compound. Even more preferably, 99 [wt%] or more and 100 [wt%] or less of the p-type light-absorbing layer 3 is composed of the cuprous oxide compound. The p-type light-absorbing layer 3 can be composed entirely of the cuprous oxide compound.

When the p-type light-absorbing layer 3 has fewer heterogeneous-phase and better crystallinity, the transmittance of the p-type light-absorbing layer 3 is higher, which is preferable. The band gap of the p-type light-absorbing layer 3 can be adjusted by including elements other than Cu and O in the p-type light-absorbing layer 3. The band gap of the p-type light-absorbing layer 3 is preferably 2.0 [eV] or more and 2.2 [eV] or less. In this range, when using silicon as a light-absorbing layer for the bottom cell in a multi-junction solar cell with the laminated body 10, and the embodiment of the laminated body 10 used for the top cell can efficiently utilize sunlight on both the top cell and the bottom cell. The p-type light-absorbing layer 3 preferably includes Sn or/and Sb.

The composition ratio of the p-type light-absorbing layer 3 described above is the overall composition ratio of the p-type light-absorbing layer 3. Further, it is preferable that the compound composition ratio of the p-type light-absorbing layer 3 satisfies the above conditions throughout the p-type light-absorbing layer 3.

The crystal grain size of the cuprous oxide compound is preferably 1.2 times or more the thickness of the p-type light-absorbing layer 3. The p-type light-absorbing layer 3 mainly composed of the cuprous oxide compound with a large crystal grain size has good film quality and when the laminated body 10 is converted into a solar cell, the short-circuit current density (Jsc) is high. Conversion efficiency is improved when the laminated body 10 is converted into a solar cell. Even when the conversion efficiency does not improve significantly when the embodiment of the laminated body 10 with a crystal grain size of the cuprous oxide compound 1.2 times or more the thickness of the p-type light-absorbing layer 3 is converted into a solar cell, the crystallinity is improved, leading to superior transmittance of the laminated body 10 and solar cell. This is preferable for applications requiring high transmittance, and also contributes to increasing the power generation amount in the bottom cell in a multi-junction solar cell.

From the above viewpoint, it is more preferable that the crystal grain size of the cuprous oxide compound is 1.2 times or more and 10 times or less (or 5 times or less), more preferably 1.5 times or more and 10.0 times or less (or 7.0 times or less), and even more preferably 2.0 times or more and 7.0 times or less the thickness of the p-type light-absorbing layer 3.

The crystal grain size of the cuprous oxide compound can be confirmed by analyzing analysis spots A1 to A9 shown in FIG. 2, for example. D1 is the length in the width direction (X direction) of the laminated body 10. D2 is the length in the depth direction (Y direction) of the laminated body 10. For example, a surface image of the laminated body 10 can be obtained using a scanning electron microscope (SEM). Note that when a solar cell having the laminated body 10 is analyzed, a surface image of the solar cell is obtained. It is preferable to perform shooting an image for evaluating the grain size by specifying the observation position from an image observed at a magnification of about 1000 times. The shooting magnification for evaluating the grain size is preferably 100 times or more and 20000 times or less, and each side of each image (for example, each side of a square shooting range) is 10 times or more and 50 times or less of the thickness of the p-type light-absorbing layer 3. In order to evaluate the crystal size larger than the thickness of the p-type light-absorbing layer 3, it is preferable that each image is a mosaic image obtained by combining multiple raster images (mosaic). From the crystals included in the p-type light-absorbing layer 3 of the image, three crystals are selected (the crystal with the longest outer circle diameter in the surface direction (vertical direction to the thickness direction of the p-type light-absorbing layer 3), the second longest outer circle diameter crystal and the third longest outer circle diameter crystal). The outer circle diameter is referred to as the diameter. The diameter of the crystal with the longest outer circle diameter is denoted as d1. The diameter of the crystal with the second longest outer circle diameter is denoted as d2. The diameter of the crystal with the third longest outer circle diameter is denoted as d3. Then, calculate the average value ((d1 + d2 + d3)/3) of the diameters of the three selected crystals. The calculated average value is defined as the first grain size. In this way, the first grain size is determined for all analysis spots and it is evaluated whether the relationship between the crystal grain size and the thickness of the p-type light-absorbing layer 3 at each analysis spot satisfies the predetermined conditions.

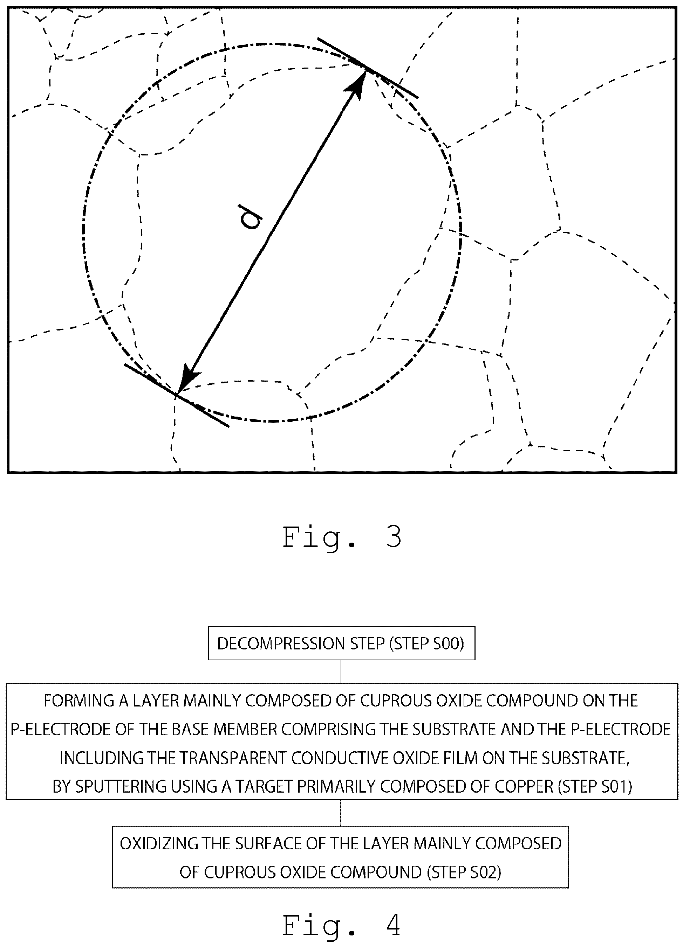

FIG. 3 illustrates a schematic diagram of the surface of the p-type light-absorbing layer 3. The schematic diagram in FIG. 3 is a part of the image of the analysis spot. The dashed lines in FIG. 3 represent grain boundaries, and one short dotted line represents a circumscribed circle of one crystal. The diameter d is the diameter of this circumscribed circle. The diameter of the circumscribed circle in FIG. 3 is 14.5 [µm], which satisfies all conditions: 1.2 times or more and 10 times or less (or 5 times or less), 1.5 times or more and 10.0 times or less (or 7.0 times or less), and 2.0 times or more and 7.0 times or less, of the thickness of the p-type light-absorbing layer 3.

When the first grain size of the cuprous oxide compound is 1.2 times or more the thickness of the p-type light-absorbing layer 3 at five or more analysis spots out of nine analysis spots, it is considered that the diameter of the cuprous oxide compound is 1.2 times or more the thickness of the p-type light-absorbing layer 3. When the first grain size of the cuprous oxide compound is 1.5 times or more the thickness of the p-type light-absorbing layer 3 at five or more analysis spots out of nine analysis spots, it is considered that the diameter of the cuprous oxide compound is 1.5 times or more the thickness of the p-type light-absorbing layer 3.

When the first grain size of the cuprous oxide compound is 1.2 times or more and 10 times or less (or 5 times or less) the thickness of the p-type light-absorbing layer 3 at five or more analysis spots out of nine analysis spots, it is considered that the diameter of the cuprous oxide compound is 1.2 times or more and 10 times or less (or 5 times or less) the thickness of the p-type light-absorbing layer 3.

When the first grain size of the cuprous oxide compound is 1.5 times or more and 10 times or less (or 7.0 times or less) the thickness of the p-type light-absorbing layer 3 at five or more analysis spots out of nine analysis spots, it is considered that the diameter of the cuprous oxide compound is 1.5 times or more and 10 times or less (or 7.0 times or less) the thickness of the p-type light-absorbing layer 3.

When the first grain size of the cuprous oxide compound is 2.0 times or more and 7.0 times or less the thickness of the p-type light-absorbing layer 3 at five or more analysis spots out of nine analysis spots, it is considered that the diameter of the cuprous oxide compound is 2.0 times or more and 7.0 times or less the thickness of the p-type light-absorbing layer 3.

From the crystals included in the p-type light-absorbing layer 3 of the image obtained by analyzing each analysis spot, select one crystal (the crystal with the longest outer circle diameter) with the longest diameter in the surface direction (vertical direction to the thickness direction of the p-type light-absorbing layer 3). The diameter of the selected crystal is denoted as d1. Then d1 is defined as the second grain size.

From the above viewpoint, it is preferable that the p-type light-absorbing layer 3 includes cuprous oxide compound crystals having a grain size of 3.0 times or more the thickness of the p-type light-absorbing layer 3 (d1 is 3.0 times or more the thickness of the p-type light-absorbing layer 3). It is more preferable that the p-type light-absorbing layer 3 includes cuprous oxide compound crystals having a grain size of 2.0 times or more and 12 times or less the thickness of the p-type light-absorbing layer 3 (d1 is 2.0 times or more and 12 times or less the thickness of the p-type light-absorbing layer 3). It is even more preferable that the p-type light-absorbing layer 3 includes cuprous oxide compound crystals having a grain size of 3.0 times or more and 12 times or less the thickness of the p-type light-absorbing layer 3 (d1 is 3.0 times or more and 12 times or less the thickness of the p-type light-absorbing layer 3).

From the above viewpoint, it is preferable that the p-type light-absorbing layer 3 includes cuprous oxide compound crystals having a grain size of 4.0 times or more the thickness of the p-type light-absorbing layer 3 (d1 is 4.0 times or more the thickness of the p-type light-absorbing layer 3).

When the second grain size of the cuprous oxide compound is 2.0 times or more the thickness of the p-type light-absorbing layer 3 at one or more analysis spots out of nine analysis spots, it is considered that the p-type light-absorbing layer 3 includes cuprous oxide compound crystals with a diameter of 3.0 times or more the thickness of the p-type light-absorbing layer 3.

When the second grain size of the cuprous oxide compound is 2.0 times or more and 12 times or less the thickness of the p-type light-absorbing layer 3 at one or more analysis spots out of nine analysis spots, it is considered that the p-type light-absorbing layer 3 includes cuprous oxide compound crystals with a diameter of 2.0 times or more and 12 times or less the thickness of the p-type light-absorbing layer 3.

When the second grain size of the cuprous oxide compound is 3.0 times or more and 12 times or less the thickness of the p-type light-absorbing layer 3 at one or more analysis spots out of nine analysis spots, it is considered that the p-type light-absorbing layer 3 includes cuprous oxide compound crystals with a diameter of 3.0 times or more and 12 times or less the thickness of the p-type light-absorbing layer 3.

The length in the stacking direction (the stacking direction between the p-type light-absorbing layer 3 and the p-electrode 2) of the p-type light-absorbing layer 3 at the thickest part captured by nine analysis spots is determined. Subsequently, the average value from the obtained nine lengths is calculated. Then, the calculated average value is defined as the thickness of the p-type light-absorbing layer 3.

It is preferable that particles whose diameter of the cuprous oxide compound crystal is 1.5 times or more the thickness of the p-type light-absorbing layer 3 occupy 60% or more of the surface area of the p-type light-absorbing layer 3. When, at five or more analysis spots out of nine, particles whose diameter of cuprous oxide compound crystal is 1.5 times or more the thickness of the p-type light-absorbing layer 3 occupy 60% or more of the surface area of the p-type light-absorbing layer 3, it is considered that particles whose diameter of cuprous oxide compound crystal is 1.5 times or more the thickness of the p-type light-absorbing layer 3 occupy 60% or more of the surface area of the p-type light-absorbing layer 3.

It is preferable that particles whose diameter of the cuprous oxide compound crystal is 1.7 times or more the thickness of the p-type light-absorbing layer 3 occupy 50% or more of the surface area of the p-type light-absorbing layer 3. When, at five or more analysis spots out of nine, particles whose diameter of the cuprous oxide compound crystal is 1.7 times or more the thickness of the p-type light-absorbing layer 3 occupy 50% or more of the surface area of the p-type light-absorbing layer 3, it is considered that particles whose diameter of the cuprous oxide compound crystal is 1.7 times or more the thickness of the p-type light-absorbing layer 3 occupy 50% or more of the surface area of the p-type light-absorbing layer 3.

It is preferable for the p-type light-absorbing layer 3 to have a p+ type (p plus type) region on the side of the p-electrode 2.

It is preferable for the p-type light-absorbing layer 3 to have a p-type (p minus type) region on the n-type layer side. It is preferable for the p-type light-absorbing layer 3 to have a p-type (p minus type) region on the n-type layer side and a p+ type (p plus type) region on the side of the p-electrode 2.

It is preferable that particles whose diameter of the cuprous oxide compound crystal is 1.2 times or more the thickness of the p-type light-absorbing layer 3 are in direct contact with the surface of the p-type light-absorbing layer 3 facing the p-electrode 2. It is preferable that particles whose diameter of the cuprous oxide compound crystal is 1.2 times or more the thickness of the p-type light-absorbing layer 3 are exposed on the surface opposite to the p-electrode 2 side of the p-type light-absorbing layer 3. It is preferable that particles whose diameter of the cuprous oxide compound crystal is 1.2 times or more the thickness of the p-type light-absorbing layer 3 are in direct contact with the surface of the p-type light-absorbing layer 3 facing the p-electrode 2 and exposed on the surface opposite to the p-electrode 2 side of the p-type light-absorbing layer 3.

It is preferable that particles whose diameter of the cuprous oxide compound crystal is 1.5 times or more the thickness of the p-type light-absorbing layer 3 are in direct contact with the surface of the p-type light-absorbing layer 3 facing the p-electrode 2. It is particles whose diameter of the cuprous oxide compound crystal is 1.5 times or more the thickness of the p-type light-absorbing layer 3 are exposed on the surface opposite to the p-electrode 2 side of the p-type light-absorbing layer 3. It is preferable that particles whose diameter of the cuprous oxide compound crystal is 1.5 times or more the thickness of the p-type light-absorbing layer 3 are in direct contact with the surface of the p-type light-absorbing layer 3 facing the p-electrode 2 and exposed on the surface opposite to the p-electrode 2 side of the p-type light-absorbing layer 3.

It is preferable that particles whose diameter of the cuprous oxide compound crystal is 1.7 times or more the thickness of the p-type light-absorbing layer 3 are in direct contact with the surface of the p-type light-absorbing layer 3 facing the p-electrode 2. It is preferable that particles whose diameter of the cuprous oxide compound crystal is 1.7 times or more the thickness of the p-type light-absorbing layer 3 are exposed on the surface opposite to the p-electrode 2 side of the p-type light-absorbing layer 3. It is preferable that particles whose diameter of the cuprous oxide compound crystal is 1.7 times or more the thickness of the p-type light-absorbing layer 3 are in direct contact with the surface of the p-type light-absorbing layer 3 facing the p-electrode 2 and exposed on the surface opposite to the p-electrode 2 side of the p-type light-absorbing layer 3.

It is preferable that particles whose diameter of the cuprous oxide compound crystal is 1.2 times or more the thickness of the p-type light-absorbing layer 3 are present overall, including on the p-electrode 2 side of the p-type light-absorbing layer 3.

It is preferable that no tiny particles (particles with a diameter of 100 [nm] or less, which is 1/10 or less the film thickness) and/or voids (voids with a diameter of 100 nm or less, which is 1/10 or less the film thickness) exist at the interface between the cuprous oxide compound particles with a diameter of 1.2 times or more the thickness of the p-type light-absorbing layer 3 and the p-electrode 2. It is preferable that 50% or more (preferably 70% or more, 90% or more) of the cuprous oxide compound particles with a diameter of 1.2 times or more the thickness of the p-type light-absorbing layer 3 are in direct contact with the p-electrode 2 without intervening tiny particles (particles with a diameter of 100 [nm] or less, which is 1/10 or less the film thickness) and/or voids (voids with a diameter of 100 [nm] or less, which is 1/10 or less the film thickness).

It is preferable that no tiny particles (particles with a diameter of 100 [nm] or less, which is 1/10 or less the film thickness) and/or voids (voids with a diameter of 100 [nm] or less, which is 1/10 or less the film thickness) exist at the interface between the cuprous oxide compound particles with a diameter of 1.5 times or more the thickness of the p-type light-absorbing layer 3 and the p-electrode 2. It is preferable that 50% or more (preferably 70% or more, 90% or more) of the cuprous oxide compound particles with a diameter of 1.5 times or more the thickness of the p-type light-absorbing layer 3 are in direct contact with the p-electrode 2 without intervening tiny particles (particles with a diameter of 100 nm or less, which is 1/10 or less the film thickness) and/or voids (voids with a diameter of 100 [nm] or less, which is 1/10 or less the film thickness).

It is preferable that no tiny particles (particles with a diameter of 100 [nm] or less, which is 1/10 or less the film thickness) and/or voids (voids with a diameter of 100 [nm] or less, which is 1/10 or less the film thickness) exist at the interface between the cuprous oxide compound particles with a diameter of 1.7 times or more the thickness of the p-type light-absorbing layer 3 and the p-electrode 2. It is preferable that 50% or more (preferably 70% or more, 90% or more) of the cuprous oxide compound particles with a diameter of 1.7 times or more the thickness of the p-type light-absorbing layer 3 are in direct contact with the p-electrode 2 without intervening tiny particles (particles with a diameter of 100 [nm] or less, which is 1/10 or less the film thickness) and/or voids (voids with a diameter of 100 [nm] or less, which is 1/10 or less the film thickness).

The p-type light-absorbing layer 3 is preferably composed overall of large-grained cuprous oxide compound crystal particles and that tiny particles (particles with a diameter of 100 [nm] or less, which is 1/10 or less the film thickness) do not exist, for example, on the p-electrode 2 side.

The element represented by M1 is included at least in a region from the interface (starting point) between the p-type light-absorbing layer 3 and the p-electrode 2 to a depth (ending point) of 20% or more of the thickness of the p-type light-absorbing layer 3 towards the side opposite the p-electrode 2, or/and a region from the interface (starting point) to a depth (ending point) of 1 [µm] or more from the interface towards an interface opposite to the p-electrode 2, the carrier concentration (average value for the whole p-type light-absorbing layer 3) is high, and the average particle size of the cuprous oxide compound in the p-type light-absorbing layer 3 in the region from the interface (starting point) between the p-type light-absorbing layer 3 and the p-electrode 2 to a depth (ending point) of 20% or more of the thickness of the p-type light-absorbing layer 3 towards the side opposite the p-electrode 2, or/and the region from the interface (starting point) to a depth (ending point) of 1 [µm] or more from the interface towards an interface opposite to the p-electrode 2 is large, then Jsc and FF of the solar cell using the laminated body 10 improve, contributing to improved conversion efficiency.

The average surface roughness deviation of the surface on the side opposite to the p-electrode 2 side of the p-type light-absorbing layer 3 is preferably 50 [nm] or more. When the surface roughness of the side opposite to the p-electrode 2 side of the p-type light-absorbing layer 3 is small, the surface is highly planar. When that surface roughness is large, the planarity is low. In other words, there is unevenness on the surface opposite to the p-electrode 2 side of the p-type light-absorbing layer 3. Due to the unevenness on the surface of the p-type light-absorbing layer 3 (the light incident side when the solar cell is fabricated) with good film quality, light is refracted at the surface of the p-type light-absorbing layer 3 and the optical path length increases, contributing to improved short circuit current density. The side opposite to the p-electrode 2 side of the p-type light-absorbing layer 3 is a side facing the n-electrode described later.

The average surface roughness deviation of the surface on the side opposite to the p-electrode 2 side of the p-type light-absorbing layer 3 is preferably 50 [nm] or more and 500 [nm] or less, more preferably 55 [nm] or more and 300 [nm] or less.

The average surface roughness deviation Ra of the surface on the side opposite to the p-electrode 2 side of the p-type light-absorbing layer 3 is determined according to the contour method (JIS B0601:2013 ISO 4287:1997). A reference length is set to be 20 times or more and 50 times or less the thickness of the p-type light-absorbing layer 3 (for example, 200 [µm]), and the surface height is acquired by measuring at intervals of 100 [nm] including the center of each analysis spot. A roughness curve (cut-off value λc (e.g., a value twice as large as the reference length or less), λs (e.g., a value twice as small as the measurement interval or less), λf (e.g., a value larger than the reference length), for example, λc is 400 [nm], λs is 20 [nm], and λf is 1 [mm].) is obtained from the cross-sectional curve of the acquired surface height, and the mean plane of each roughness curve is calculated at analysis spots A1 to A9. The average surface roughness deviation of the p-type light-absorbing layer 3 on the side opposite to the p-electrode 2 side is the average value of the absolute values of each surface height from the mean plane. Preferably, the surface roughness is measured non-contact. Non-contact measurement allows for the same measurements to be taken when the laminated body 10 is fabricated into a solar cell. The other averages are also the average values of the values obtained at analysis spots A1 to A9.

The carrier concentration in the p-type light-absorbing layer 3 is preferably 5.0 × 10¹⁴ [cm⁻³] or more. When a high-temperature sputtering method is used to form the p-type light-absorbing layer 3, cuprous oxide crystals grow to be larger than the film thickness of the p-type light-absorbing layer 3. As the cuprous oxide crystals grow, the film quality improves; however, when the sputtering is started under high-temperature conditions, the carrier concentration tends to decrease. In this embodiment, a high carrier concentration (carrier doping) is achieved while maintaining large-grained cuprous oxide by adopting the following film formation method. By increasing the carrier concentration in the large-grained cuprous oxide compound in this embodiment, the conversion efficiency of a high-efficiency solar cell is further improved according to a simulation that changed the carrier concentration when using a solar cell with a p-type light-absorbing layer 3 including large-grained cuprous oxide. Therefore, maintaining a large grain size and increasing the carrier concentration contribute to improving the performance of devices such as solar cells utilizing laminated bodies.

The carrier concentration in the p-type light-absorbing layer 3 is more preferably 8.0 × 10¹⁴ [cm⁻³] or more, even more preferably 9.0 × 10¹⁴ [cm⁻³] or more, and most preferably 1.0 × 10¹⁵ [cm⁻³] or more. As the carrier concentration increases, the short circuit current density improves when the laminated body 10 of this embodiment is used in a solar cell. The improvement in short circuit current density leads to improvements in fill factor (FF) and conversion efficiency of the solar cell.

When impurities are added to the cuprous oxide compound, the crystal growth can be hindered as the carrier concentration becomes extremely high. When crystal growth is inhibited, even when the grain size of the cuprous oxide compound is large, it will become a few hundred nano-meter or less. Since the p-type light-absorbing layer 3 preferably has a large grain size for the cuprous oxide compound, the carrier concentration in the p-type light-absorbing layer 3 is preferably 1.0 × 10¹⁸ [cm⁻³] or less, more preferably 1.0 × 10¹⁷ [cm⁻³] or less, and most preferably 5.0 × 10¹⁶ [cm⁻³] or less.

The carrier concentration in the p-type light-absorbing layer 3 is determined using a Hall effect measurement device (manufactured by Toyo Technica Co., Ltd.) based on the van der Pauw method, measuring the Hall effect at room temperature in an atmospheric environment.

The mobility of the p-type light-absorbing layer 3 is preferably 10 [cm²/(V·s) ] or more, more preferably 30 [cm²/(V·s)] or more, and most preferably 50 [cm²/(V·s)] or more. The p-type light-absorbing layer 3 has high mobility due to its large grain size and low defect density, and the absence of unintended impurities. When the laminated body 10 is fabricated into a solar cell, the mobility contributes to an improvement in Jsc (short-circuit current density).

The mobility of the p-type light-absorbing layer 3 is determined by measuring the Hall effect at room temperature in an atmospheric environment using a AC Hall effect measurement device (manufactured by Toyo Technica Co., Ltd.) and applying the van der Pauw method.

Next, the manufacturing method for the laminated body 10 will be explained. FIG. 4 shows a flowchart of the manufacturing method for the laminated body 10. The manufacturing method for the laminated body 10 includes forming a layer mainly composed of cuprous oxide compound on the p-electrode 2 of the base member comprising the substrate 1 and the p-electrode 2 including the transparent conductive oxide film on the substrate 1, by sputtering using a target primarily composed of copper (STEP S01). A decompression step (STEP S00) can be optionally performed prior to forming (STEP S01) the layer mainly composed of cuprous oxide compound. Optionally, after the step S01 of forming the layer mainly composed of cuprous oxide compound and before forming the n-type layer 4, a step S02 in which oxidizing the surface of the layer mainly composed of cuprous oxide compound can be performed.

Sputtering may be any of RF sputtering, DC magnetron sputtering, DC pulse sputtering, RF magnetron sputtering, and ion beam sputtering.

The target primarily composed of copper preferably has a purity of 99.99% or higher. A purity of 99.995% or higher is more preferable. A purity of 99.999% or higher is even more preferable. Using a high-purity copper target allows for obtaining the p-type light-absorbing layer 3 that is substantially a Cu₂O single phase and doped with impurities as a p-type dopant. When elements (e.g., Si) are included in the target used to form the p-type light-absorbing layer 3, the purity of copper does not need to meet such high requirements; and a purity of 95% or higher is preferable, with 98% or higher being more preferable.

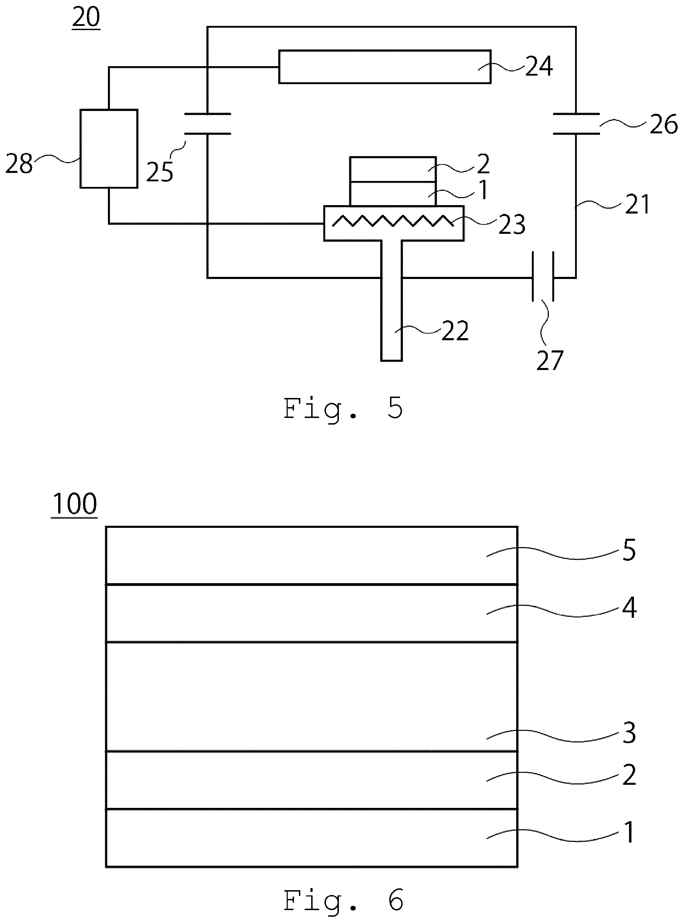

FIG. 5 shows a schematic diagram of a manufacturing apparatus 20 for producing the laminated body 10 as an example. The manufacturing apparatus 20 includes a chamber 21, a substrate holder 22, a heating element 23, a target 24, an inert gas supply element 25, a reactive gas supply element 26, an exhaust element 27, and a power supply 28. FIG. 5 shows a view of the base member on which the p-electrode 2 is formed on the substrate 1 being placed on the substrate holder 22.

The chamber 21 is a container that houses components such as the substrate holder 22 in the manufacturing apparatus 20. The chamber 21 may be, for example, a vacuum chamber.

The substrate holder 22 is a member on which the base member to be subjected to film formation is placed. The heating element 23 can be incorporated into the substrate holder 22.

The heating element 23 can heat the base member.

The target 24 is a copper-based target as described above.

The inert gas supply element 25 is configured to supply an inert gas such as Ar into the chamber 21. Nitrogen gas can be supplied into the chamber 21 by the inert gas supply element 25. The inert gas and nitrogen gas can be separately supplied into the chamber 21 by different piping systems of the inert gas supply element 25.

The reactive gas supply element 26 is configured to supply a reactive gas such as oxygen into the chamber 21. Nitrogen gas can also be supplied into the chamber 21 by the reactive gas supply element 26. Oxygen gas and nitrogen gas can be separately supplied into the chamber 21 by different piping systems of the reactive gas supply element 26.

The exhaust element 27 is configured to exhaust gases in the chamber 21 to the outside.

The power supply 28 is configured to apply voltage between the substrate holder 22 and the target 24.

The atmosphere of sputtering is preferably an oxidizing atmosphere mixed with inert gas and oxygen gas. More preferably, the sputtering atmosphere consists of inert gas and oxygen gas. Argon gas is preferable as the inert gas.

The element represented by M1 is preferably introduced into the chamber 21 together with Cu and oxygen during sputtering. The element represented by M1 can be included in a Cu alloy used for the target 24, or it can be included in a compound of the element M1 included in the target 24. Alternatively, a target 24 including both Cu and an element represented by M1 can be used to deposit a cuprous oxide compound film. The gas including the element represented by M1 can also be mixed with inert gas and oxygen gas and included in the sputtering atmosphere. For example, Li, Na, K, Si, Ge, C, P, and Bi can each be included as compounds in the Cu target 24. For example, Al, Ga, In, Sn, and Sb can be used as a sputtering target by alloying them with Cu. For example, N can be introduced into the sputtering chamber 21.

Sputtering is performed on the base member, for example, which has the p-electrode 2 formed on the substrate 1. Sputtering is performed on the surface of the p-electrode 2 to deposit the p-type light-absorbing layer 3 (the layer mainly composed of cuprous oxide compound) on the p-electrode 2. Preferably, the decompression step (S00) for reducing the pressure in the chamber 21 to 5.0 × 10⁻³ [Pa] or less after placing the base member with the p-electrode 2 formed thereon on the substrate holder 22 is performed before sputtering. The decompression step (S00) can be performed within the chamber 21 for sputtering, or it can be performed within a sub-chamber not shown in the figure. Oxygen is not introduced during the decompression process, which is different from sputtering. The substrate 1 can be used as a substrate for a solar cell using the laminated body 10. The p-electrode 2 can be formed by sputtering onto the substrate 1.

Sputtering is performed in two temperature ranges. The sputtering is carried out continuously in a low-temperature range and then in a high-temperature range without stopping the reaction. To avoid interruption, the base member is supplied with Cu, oxygen, and the element represented by M1 while the temperature range changes from the low-temperature range to the high-temperature range. For example, when the reaction is stopped when the temperature range changes, a p-type light-absorbing layer 3 including fine-grained cuprous oxide compound will be formed on the side of the p-electrode 2 at the end of sputtering. In this embodiment, since a p-type light-absorbing layer 3 with fewer or no fine grains of cuprous oxide compound is preferable, Cu, oxygen, and the element represented by M1 are continuously supplied from the start of the sputtering reaction until the end of the sputtering process, preferably.

The element represented by M1 is preferably included in the sputtering atmosphere during the high-temperature range sputtering, but the element represented by M1 may not be included in the sputtering atmosphere.

The low-temperature range sputtering will be described. The temperature of the base member during sputtering of the cuprous oxide compound layer in the low-temperature range is preferably 25 [°C] or more and 600 [°C] or less, which is at least 50 [°C] lower than the maximum temperature in the high-temperature range. More preferably, the sputtering temperature during the low-temperature range sputtering is at least 100 [°C] lower than the maximum temperature in the high-temperature range, and even more preferably at least 150 [°C] lower.

The sputtering duration in the low-temperature range is preferably 5% or more and 200% or less of the sputtering duration in the high-temperature range, more preferably 5% or more and 100% or less, and even more preferably 5% or more and 50% or less. When the sputtering duration in the low-temperature range is too short, the amount of the element represented by M1, which is included as an impurity in the p-type light-absorbing layer 3, will be reduced. When the sputtering time in the low-temperature range is relatively long, crystal growth of the cuprous oxide compound may become insufficient or the activation rate of impurities may decrease.

The sputtering in the low-temperature range preferably involves continuous or intermittent temperature rise. For example, sputtering starts at a temperature of 100 [°C] and rises continuously until it exceeds 600 [°C], at which point it transitions into high-temperature range sputtering.

The average temperature of the base member during the low-temperature range sputtering is preferably at least 100 [°C] lower, more preferably at least 200 [°C] lower, and even more preferably at least 250 [°C] lower than the average temperature of the base member during the high-temperature range sputtering.

The minimum temperature of the base member during the low-temperature range sputtering is preferably 550 [°C] or less, more preferably 500 [°C] or less, and even more preferably 450 [°C] or less.

The minimum temperature of the base member during the low-temperature range sputtering is preferably 50 [°C] or more, and more preferably 100 [°C] or more.

Lower temperatures during the low-temperature range sputtering facilitate the incorporation of impurities into the cuprous oxide compound. The high-temperature range sputtering promotes crystal growth; thus it makes incorporating impurities into the cuprous oxide compound harder. From a crystal growth perspective, this is advantageous. However, from an impurity doping viewpoint, it is disadvantageous. When the layer mainly composed of cuprous oxide compound is formed and then impurities are doped by impregnation or other methods, the distribution of impurities tends to be higher on the side opposite the p-electrode 2. Considering conversion efficiency improvements, the carrier concentration in the p-type light-absorbing layer 3 is preferably high overall, or at least high on the side of the p-electrode 2. Therefore, it is desirable to perform sputtering in the low-temperature range first on the p-electrode 2 and then perform sputtering in the high-temperature range.

The high-temperature range sputtering will be described. The temperature of the base member during sputtering of the layer mainly composed of cuprous oxide compound in the high-temperature range is preferably more than 600 [°C] and 1000 [°C] or less. Depending on the heat resistance of the base member, the temperature during sputtering of the layer mainly composed of cuprous oxide compound is preferably more than 600 [°C] and 850 [°C] or less. Preferably, the temperature more than 700 [°C] and 850 [°C] or less to further increase the crystal grain size of the cuprous oxide. While the p-type light-absorbing layer 3 with transparency can be formed even at temperatures 600 [°C] or less, for example, when the heating temperature during sputtering is 400 [°C], instead of a suitable oxygen partial pressure (0.55 × d [Pa] or more and 1.00 × d [Pa] (deposition rate d [µm/min])), adopting an oxygen partial pressure in the chamber 21 that considers the deposition rate as shown below can further result in the formation of a p-type light-absorbing layer 3 with better film quality.

From the viewpoint of improving film quality, the temperature of the base member during the high-temperature range sputtering of the layer mainly composed of cuprous oxide compound is more preferably 630 [°C] or more and 850 [°C] or less, and even more preferably 630°C or more and 800 [°C] or less.

When the temperature of the base member during the high-temperature range sputtering is more than 600 [°C] and 700 [°C] or less, for example, it is preferable that sputtering deposition can be performed using a typical white glass substrate. When the temperature of the base member during the high-temperature range sputtering is more than 700 [°C] and 850 [°C] or less, for example, sputtering deposition can be performed using high heat-resistant white glass, resulting in the formation of even higher quality films. When the temperature of the base member during the high-temperature range sputtering is more than 850 [°C] or more and 1000 [°C] or less, for example, sputtering deposition can be performed using quartz glass, resulting in the formation of even higher quality films.

From the viewpoint of depositing better quality cuprous oxide, it is more preferable that the oxygen partial pressure in the chamber during sputtering (both high-temperature range sputtering and low-temperature range sputtering) be 0.20 × d [Pa] or more and 0.50 × d [Pa] or less (the unit of the deposition rate can be ignored when multiplying the deposition rate by 0.20 to 0.50).

From the viewpoint of further improving short-circuit current density, the oxygen partial pressure (both high-temperature range sputtering and low-temperature range sputtering) is more preferably 0.20 × d [Pa] or more and 0.45 × d [Pa] or less when the deposition rate is d [µm/min], and even more preferably 0.25 × d [Pa] or more and 0.40 × d [Pa] or less. When aiming for a larger standard deviation, it is preferable to adopt a higher oxygen partial pressure within the above range.

The oxygen partial pressure in chamber 21 during sputtering (both high-temperature range sputtering and low-temperature range sputtering) is preferably 0.01 [Pa] or more and 1.00 [Pa] or less. Low oxygen partial pressures can lead to the formation of heterogeneous phases such as Cu, while high oxygen partial pressures can lead to the formation of heterogeneous phases such as CuO.

The total pressure in chamber 21 during sputtering (both high-temperature range sputtering and low-temperature range sputtering) is typically 0.1 [Pa] or more and 10 [Pa] or less.

When the deposition rate during sputtering is slow, the film formation time will be longer, so a deposition rate of 0.03 [µm/min] or more is preferable. A preferred deposition rate is 2.00 [µm/min] or less. For example, when the deposition area is large, a high deposition rate can reduce the uniformity of the p-type light-absorbing layer 3. A more preferred deposition rate for further improving film quality is 1.00 [µm/min] or less, and even more preferably 0.50 [µm/min] or less. Considering practicality and film quality, a preferable deposition rate is 0.04 [µm/min] or more and 0.40 [µm/min] or less.

An oxidation treatment may be performed after high-temperature range sputtering. The oxidation treatment oxidizes a very thin region on the surface of the film deposited by sputtering. It is preferable to adopt any one of the following conditions 1 through 4 for the oxidation conditions of the oxidation treatment.

### (Condition 1)

In the oxidation treatment, the oxygen partial pressure is 5000 [Pa] or more and 200000 [Pa] or less; the water-vapor concentration is 9.4x10⁻¹ [g/m³] or more and 2.5×10³ [g/m³] or less; the processing temperature is 40 [°C] or more and 150 [°C] or less; and the processing duration is 5 seconds or more and 150 minutes or less. The atmosphere (gas) for the oxidation treatment includes oxygen. Ozone with a concentration of 0.0% to 0.1% (maximum 1 [Pa]) may be included in the atmospheres of conditions 1, 2, and 4 for the oxidation treatment. The atmosphere for the oxidation treatment may also include carbon monoxide, carbon dioxide, hydrocarbons, hydrogen, or other substances that are inevitably present in the atmosphere, in addition to oxygen. For example, carbon monoxide, carbon dioxide, hydrocarbons, or hydrogen, or other substances that are inevitably present in the atmosphere, may be present in the oxidation treatment atmosphere at 5000 ppm or less. The atmosphere for the oxidation treatment may further include inert gases such as nitrogen and argon, or hydrogen. Because the atmosphere for the oxidation treatment does not substantially include reactive gases other than oxygen and ozone, no reactive gases other than oxygen and ozone are introduced into the chamber in which the oxidation treatment is performed. Therefore, it is preferable to introduce only oxygen gas, optionally ozone, and/or inert gas into chamber 21. The sum of the oxygen partial pressure and the inert gas partial pressure (=[oxygen partial pressure]+[inert gas partial pressure])/total pressure of the gas in the atmosphere for the oxidation treatment excluding steam) is preferably 99.0% or more and 100% or less, and more preferably 99.3% or more and 100% or less (or 99.3% or more and 99.9% or less). Some preferred conditions 1 are listed below.

In the oxidation treatment, the water-vapor concentration is 9.4x10⁻¹ [g/m³] or more and 2.5×10³ [g/m³] or less; the processing duration, the processing temperature, and the oxygen partial pressure in the oxidation treatment are one of following conditions.

The processing duration is 10 seconds or more and less than 5 minutes, the processing temperature is 40 [°C] or more and less than 110 [°C], and the oxygen partial pressure is 50000 [Pa] or more and 100000 [Pa] or less.

The processing duration is 10 seconds or more and less than 5 minutes, the processing temperature is 110 [°C] or more and 150 [°C] or less, and the oxygen partial pressure is 15000 [Pa] or more and less than 50000 [Pa].

The processing duration is 5 minutes or more and less than 10 minutes, the processing temperature is 40 [°C] or more and less than 80 [°C], and the oxygen partial pressure is 15000 [Pa] or more and 100000 [Pa] or less.

The processing duration is 10 minutes or more and less than 60 minutes, the processing temperature is 40 [°C] or more and less than 80 [°C], and the oxygen partial pressure is 15000 [Pa] or more and 40000 [Pa] or less.

The processing duration is 60 minutes or more and less than 90 minutes, the processing temperature is 40 [°C] or more and 120 [°C] or less, and the oxygen partial pressure is 15000 [Pa] or more and 35000 [Pa] or less;

The processing duration is 90 minutes or more and 150 minutes or less, the processing temperature is 40 [°C] or more and 60 [°C] or less, and the oxygen partial pressure is 5000 [Pa] or more and 21000 [Pa] or less.

In the oxidation treatment, the oxygen partial pressure is 5000 [Pa] or more and 50000 [Pa] or less; the processing temperature is 50 [°C] or more and 150 [°C] or less; the processing duration is 5 minutes or more and 60 minutes or less; and the water-vapor concentration is 9.4x10⁻¹ [g/m³] or more and 2.5×10¹ [g/m³] or less.

In the oxidation treatment, the processing temperature is 75 [°C] or more and 125 [°C] or less; the oxygen partial pressure is 5000 [Pa] or more and 100000 [Pa] or less; the processing duration is 5 minutes or more and 45 minutes or less; and the water-vapor concentration is 9.4x10⁻¹ [g/m³] or more and 2.5×10¹ [g/m³] or less.

The processing temperature is 80 [°C] or more and 120 [°C] or less, the oxygen partial pressure is 5000 [Pa] or more and 100000 [Pa] or less, the processing duration is 10 minutes or more and 45 minutes or less, and water-vapor concentration is 9.4x10⁻¹ [g/m³] or more and 2.5×10¹ [g/m³] or less.

The processing duration is 10 seconds or more and less than 5 minutes, the processing temperature is 110 [°C] or more and 150 [°C] or less, and the oxygen partial pressure is 15000 [Pa] or more and 50000 [Pa] or less.

The processing duration is 5 minutes or more and less than 10 minutes, the processing temperature is 40 [°C] or more and less than 80 [°C], and the oxygen partial pressure is 15000 [Pa] or more and 100000 [Pa] or less.

The processing duration is 10 minutes or more and less than 60 minutes, the processing temperature is 40 [°C] or more and less than 80 [°C], and the oxygen partial pressure is 15000 [Pa] or more and 40000 [Pa] or less.

The processing duration is 90 minutes or more and less than 150 minutes, the processing temperature is 40 [°C] or more and 60 [°C] or less, and the oxygen partial pressure is 5000 [Pa] or more and 21000 [Pa] or less.

### (Condition 2)

In the oxidation treatment, the oxygen partial pressure is 100 [Pa] or more and less than 5000 [Pa]; the processing temperature is 100 [°C] or more and 300 [°C] or less in the oxidation treatment; and the processing duration is 1 second or more and 90 minutes or less. Some preferred condition 2 are listed below.

In the oxidation treatment, the oxygen partial pressure is 100 [Pa] or more and less than 5000 [Pa]; the processing temperature is 125 [°C] or more and 250 [°C] or less; and the processing duration is 1 second or more and 90 minutes or less.

In the oxidation treatment, the oxygen partial pressure is 300 [Pa] or more and 2000 [Pa] or less; the processing temperature is 180 [°C] or more and 250 [°C] or less; and the processing duration is 5 seconds or more and 45 minutes or less.

In the oxidation treatment, the oxygen partial pressure is 500 [Pa] or more and 2000 [Pa] or less; the processing temperature is 180 [°C] or more and 250 [°C] or less; and the processing duration is 1 minute or more and 30 minutes or less.

In the oxidation treatment, the oxygen partial pressure is 100 [Pa] or more and 2000 [Pa] or less; the processing temperature is 250 [°C] or more and 300 [°C] or less; and the processing duration is 1 minute or more and less than 10 minutes.

In the oxidation treatment, the oxygen partial pressure is 1000 [Pa] or more and less than 5000 [Pa]; the processing temperature is 200 [°C] or more and less than 250 [°C]; and the processing duration is 1 minute or more and less than 10 minutes.

In the oxidation treatment, the oxygen partial pressure is 1000 [Pa] or more and less than 5000 [Pa]; the processing temperature is 100 [°C] or more and 250 [°C] or less; and the processing duration is 10 minutes or more and 60 minutes or less.

In the oxidation treatment, the oxygen partial pressure is 500 [Pa] or more and less than 5000 [Pa]; the processing temperature is 100 [°C] or more and 175 [°C] or less; and the processing duration is 10 minutes or more and 30 minutes or less.

In the oxidation treatment, the oxygen partial pressure is 300 [Pa] or more and 1500 [Pa] or less; the processing temperature is 150 [°C] or more and 200 [°C] or less; and the processing duration is 10 minutes or more and 30 minutes or less.

In the oxidation treatment, the oxygen partial pressure is 1000 [Pa] or more and less than 5000 [Pa]; the processing temperature is 100 [°C] or more and 150 [°C] or less; and the processing duration is longer than 60 minutes and 90 minutes or less.

### (Condition 3)

In the oxidation treatment, the ozone partial pressure is 5 [Pa] or more and 200 [Pa] or less; the processing temperature is 273 [K] or more and 323 [K] or less; and the processing duration is 1 second or more and 60 minutes or less. Some preferred conditions for the condition 3 are listed below.

In the oxidation treatment, the ozone partial pressure is 7 [Pa] or more and 100 [Pa] or less; the processing temperature is 283 [K] or more and 308 [K] or less; and the processing duration is 1 minute or more and 30 minutes or less.

In the oxidation treatment, the ozone partial pressure is 10 [Pa] or more and 50 [Pa] or less; the processing temperature is 283 [K] or more and 308 [K] or less; and the processing duration is 1 minute or more and 10 minutes or less.

### (Condition 4)

In the oxidation treatment, the processing duration is 1 hour or more and 1600 hours or less; and the oxygen concentration is 5.0×10⁻⁸ [g/L] or more and 5.0×10⁻⁵ [g/L]. Some preferred condition 4 are listed below.

In the oxidation treatment, the processing duration is 1 hour or more and 1600 hours or less; the oxygen concentration is 5.0×10⁻⁸ [g/L] or more and 5.0×10⁻⁵ [g/L]; the water-vapor concentration is 5.0×10⁻⁸ [g/L] or more and 5.0×10⁻⁵ [g/L] or less; and the processing temperature is 0 [°C] or more and 100 [°C] or less.

Before and after the oxidation treatment, it is preferable to store the member on which a layer mainly composed of cuprous oxide compound has been deposited by sputtering in order to prevent unintentional oxidation reactions. After the oxidation treatment, it is preferable to store the oxidized member in an atmosphere with an oxygen partial pressure of 50 [Pa] or less and a temperature of 80 [°C] or less, more preferably 50 [°C] or less, or forming an n-type layer 4 following the oxidation treatment for solar cells. For example, before forming the n-type layer 4, the oxidized member can be stored in an air atmosphere (with the same member temperature) of 30 [°C] or less for 1 hour or less, more preferably 30 minutes or less. Before oxidation treatment, it is preferable to store the member in an atmosphere with an oxygen partial pressure of 50 [Pa] or less and a temperature of 80 [°C] or less, more preferably 50 [°C] or less, or store it in an air atmosphere of 30 [°C] or less for 1 hour or less, more preferably 30 minutes or less. In these storage atmospheres, ozone may be included at a concentration of 0.1% or less with respect to the oxygen partial pressure.

In these storage atmospheres, the water-vapor concentration (mass/volume) is preferably 5.0×10⁻⁸ [g/L] or more and 5.0×10⁻⁵ [g/L] or less, and more preferably 5.0×10⁻⁸ [g/L] or more and 4.0×10⁻⁵ [g/L] or less.

In these storage atmospheres, no plasma-treated gas is included, preferably.

When the member on which the layer mainly composed of cuprous oxide compound has been deposited is cooled after sputtering and the oxidation treatment, for example, the member is preferably cooled in an atmosphere with an oxygen partial pressure of 10⁻⁶ [Pa] or more and 10⁴ [Pa] or less at a cooling rate of -10³ [K/min] or more and -0.1 [K/min] or less. The temperature (or the temperature of the member after cooling) of the member on which the layer mainly composed of cuprous oxide compound has been deposited after cooling is preferably -80 [°C] or more and 250 [°C] or less, for example.

The laminated body 10 manufactured by this method has a transmittance of light with a wavelength of 700 nm or more and 1000 nm or less at 50% or more, and has very excellent light transmittance. The laminated body 10 with excellent transparency is suitably used as a top cell for a multi-junction solar cell that can generate electricity with high efficiency even in transparent solar cells and bottom cells.

### (SECOND EMBODIMENT)

A second embodiment relates to a solar cell. FIG. 6 shows a cross-sectional diagram of the solar cell 100 according to the second embodiment. As shown in FIG. 6, the solar cell 100 according to this embodiment includes the substrate 1, the p-electrode which is a first electrode, the p-type light-absorbing layer 3, an n-type layer 4, and the n-electrode 5 which is a second electrode. An intermediate layer not shown in the figure may be included between the n-type layer 4 and the n-electrode 5. Sunlight can enter from either the n-electrode 5 side or the p-electrode 2 side, but it is more preferable for sunlight to enter from the n-electrode 5 side. The solar cell 100 according to this embodiment is a transparent solar cell, so it is preferably used on the top cell side (light incident side) of a multi-junction solar cell. In FIG. 6, the substrate 1 is provided on the opposite side of the p-type light-absorbing layer 3 from the p-electrode 2, but the substrate 1 may be provided on the opposite side of the n-type layer 4 from the n-electrode 5. The following explanation will be given for the form shown in FIG. 6, but except for the position difference of the substrate 1, the form with the substrate 1 on the n-electrode 5 side is the same. In the solar cell 100 according to this embodiment, light enters from the n-electrode 5 side toward the p-electrode 2 side.

The solar cell 100 according to this embodiment uses a transparent electrode for both the p-electrode 2 and the n-electrode 5. As a result, the transparency of light in a wavelength band of 700 [nm] or more and 1200 [nm] or less is high, and it becomes a red (reddish brown), yellow, or orange colored transparent solar cell.

When the elements of the n-type layer 4 diffuse into the p-type light-absorbing layer 3 and/or the elements of the p-type light-absorbing layer 3 diffuse into the n-type layer 4, a mixed region with a thickness of 20 [nm] or less may exist between the p-type light-absorbing layer 3 and the n-type layer 4. In this mixed region, 90 [atomic%] or less of the metal elements are metals included in the p-type light-absorbing layer 3, and further 10 [atomic%] or more of the metal elements are metal elements included in the n-type layer 4.

When a mixed region exists, there are cases where the p-type light-absorbing layer 3 includes metals or the others that are not included in the target 24 used for forming the p-type light-absorbing layer 3, but includes metals or the others in the n-type layer 4.

The n-type layer 4 is an n-type semiconductor layer. The n-type layer 4 is positioned between the p-type light-absorbing layer 3 and the n-electrode 5. Preferably, the n-type layer 4 is provided on the p-type light-absorbing layer 3. The n-type layer 4 can be formed, for example, by the ALD method. An intermediate layer not shown in the figure may be provided between the p-type light-absorbing layer 3 and the n-type layer 4.

The n-type layer 4 positioned on the side of the p-type light-absorbing layer 3 preferably includes a compound (oxide) including Ga as its main component. The n-type layer 4 may include other oxides mixed into the oxide including Ga as its main component, or other elements may be doped into the oxide including Ga as its main component, or other oxides may be mixed with the oxide including Ga as its main component and doped with other elements. The n-type layer 4 can be a single layer or a multilayer. Among the metal elements included in the n-type layer 4 positioned on the side of the p-type light-absorbing layer 3, it is preferable for Ga to account for 40 [atomic%] or more, and more preferably 50 [atomic%] or more. The metal element including Ga in the n-type layer 4 may be inclined from the p-type light-absorbing layer 3 side toward the n-electrode 5 side. When the n-type layer 4 is a multilayer semiconductor layer (for example, two layers), it is designated as a first n-type layer and a second n-type layer from the p-type light-absorbing layer 3 side. An element represented by M2 (other than Ga) included in the first n-type layer is preferably less than the element represented by M2 included in the second n-type layer. When the first n-type layer is a compound (oxide) including Ga as its main component, the second n-type layer preferably comprises a compound (oxide) with Zn as its main component and including Sn or the like.

The n-type layer 4 located on the side of the p-type light-absorbing layer 3 preferably comprises an oxide including an element represented by M2 and Ga. The oxide including Ga as a main component is, for example, the oxide including the element represented by M2 and Ga. The n-type layer 4 located on the side of the p-type light-absorbing layer 3 preferably comprises the oxide including Ga and the element represented by M2 which is one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd. The n-type layer 4 located on the side of the p-type light-absorbing layer 3 preferably comprises 90 [wt%] or more and 100 [wt%] or less of the oxide including Ga and the element represented by M2 which is one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd. The compound including Ga as a main component in the n-type layer 4 located on the side of the p-type light-absorbing layer 3 preferably has an average composition represented by Gah1M2i1O j1. h1, i1, and j2 preferably satisfy 1.8 ≤ h1 ≤ 2.1, 0.0 ≤ i1 ≤ 0.2, and 2.9 ≤ j1 ≤ 3.1.

The n-type layer 4 located on the side of the p-type light-absorbing layer 3 preferably includes 90 [wt%] or more and 100 [wt%] or less of an oxide including the element M2 and Ga. More preferably, the n-type layer 4 located on the side of the p-type light-absorbing layer 3 includes 95 [wt%] or more and 100 [wt%] or less of an oxide including the element M2 and Ga. Even more preferably, the n-type layer 4 located on the side of the p-type light-absorbing layer 3 includes 98 [wt%] or more and 100 [wt%] or less of a compound represented by the oxide including the element M2 and Ga. The Cu included in the n-type layer 4 is not included in the raw material for forming the n-type layer 4, but is Cu diffused from the p-type light-absorbing layer 3. When other elements are used during the formation of the p-type light-absorbing layer 3, these elements may also diffuse into the n-type layer 4.

The film thickness of the n-type layer 4 is typically 3 [nm] or more and 100 [nm] or less. When the thickness of the n-type layer 4 is less than 3 [nm], a leakage current may occur when the coverage of the n-type layer 4 is poor, which may deteriorate the characteristics. The film thickness is not limited to the above when the coverage is good. When the thickness of the n-type layer 4 exceeds 50 [nm], characteristic deterioration due to excessive high resistance of the n-type layer 4 and short-circuit current decrease due to reduced transmittance may occur. Therefore, the thickness of the n-type layer 4 is more preferably 3 [nm] or more and 20 [nm] or less, and even more preferably 5 [nm] or more and 20 [nm] or less.

The n-electrode 5 is an electrode on the side of the n-type layer 4 that has light transmittance for visible light. Preferably, the n-electrode 5 is in direct contact with the n-type layer 4.

A transparent conductive oxide film is preferably used for the n-electrode 5. Examples of the transparent conductive oxide films used for the n-electrode 5 include one or more semiconductor conductive films selected from the group consisting of indium tin oxide, aluminum-doped zinc oxide, boron-doped zinc oxide, gallium-doped zinc oxide, indium-doped zinc oxide, titanium-doped indium oxide, indium gallium zinc oxide, and hydrogen-doped indium oxide. The dopants for the film such as tin oxide can be selected from one or more elements selected from the group consisting of In, Si, Ge, Ti, Cu, Sb, Nb, Ta, W, Mo, F, and Cl, without particular limitation. The n-electrode 5 can include a mesh or line-shaped electrode to reduce the resistance of the transparent conductive oxide film. The mesh or line-shaped electrodes are not particularly limited and may include Mo, Au, Cu, Ag, Al, Ta, W, etc. Graphene can also be used for the n-electrode 5. It is preferable that graphene is laminated with silver nanowires.

The thickness of the n-electrode 5 is not particularly limited, but is typically 30 [nm] or more and 2 [µm] or less, as determined by cross-sectional observation using an electron microscope or a step meter.

The n-electrode 5 is preferably formed by ALD (Atomic Layer Deposition) or sputtering.

The solar cell 100 using the laminated body 10 can improve its characteristics due to the high film quality of the p-type light-absorbing layer 3.

### (THIRD EMBODIMENT)

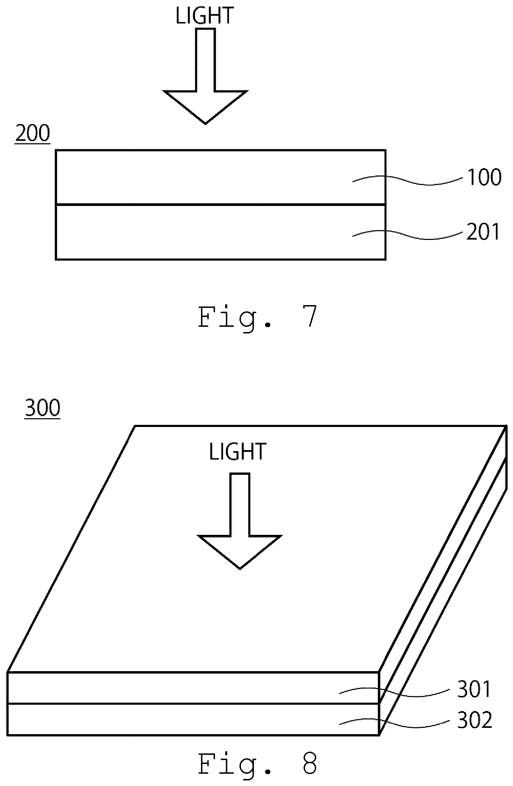

A third embodiment relates to a multi-junction solar cell. FIG. 7 shows a cross-sectional schematic diagram of the multi-junction solar cell according to this embodiment. The multi-junction solar cell 200 in FIG. 7 includes a second solar cell 201 on the light incident side, along with the solar cell (first solar cell) 100 according to the second embodiment. The light absorbing layer of the second solar cell 201 has a smaller bandgap than the p-type light-absorbing layer 3 of the solar cell 100 according to the second embodiment. The multi-junction solar cell 200 of the embodiment also includes three or more solar cells jointed together.

Since the bandgap of the p-type light absorbing layer (cuprous oxide) 3 of the first solar cell 100 according to the second embodiment is about 2.0 [eV] or more and 2.2 [eV] or less, the bandgap of the light absorbing layer of the second solar cell 201 is preferably 1.0 [eV] or more and 1.6 [eV] or less. As for the light absorbing layer of the second solar cell 201, it is preferable to use one or more compound semiconductor layers selected from the group consisting of CIGS-based and CdTe-based compounds with a high In content ratio, crystalline silicon, and perovskite type compounds.

### (Fourth Embodiment)

A fourth embodiment relates to a solar cell module. FIG. 8 shows a perspective schematic diagram of the solar cell module 300 according to this embodiment. The solar cell module 300 in FIG. 8 is a stacked solar cell module comprising the first solar cell module 301 and the second solar cell module 302. The first solar cell module 301is on the light incident side and utilizes the solar cell 100 according to the second embodiment. It is preferable that the second solar cell module 302 uses the second solar cell 201.

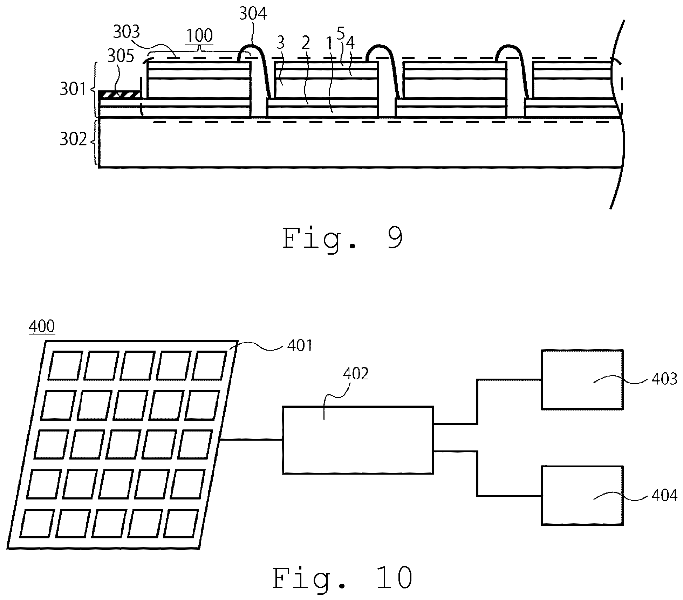

FIG. 9 shows a cross-sectional diagram of the solar cell module 300. FIG. 9 details the structure of the first solar cell module 301, but does not show the structure of the second solar cell module 302. The structure of the solar cell module for the second solar cell module 302 can be selected appropriately depending on the light absorbing layer or other components used in the solar cell. In FIG. 9, the solar cell module 300 comprises multiple dashed-line enclosed submodules 303 where several solar cells 100 are connected electrically in series by wiring 304 and arranged horizontally. The submodules 303 are further electrically connected in parallel or series. Adjacent submodules 303 are electrically connected via busbars 305.

Adjacent solar cells 100 have the n-electrode 5 on the top side and the p-electrode 2 on the bottom side, which are connected by wiring 304. The solar cell 100 according to this fourth embodiment is similar to the solar cell 100 according to the second embodiment, comprising the substrate 1, the p-electrode 2, the p-type light absorbing layer 3, the n-type layer 4 and the n-electrode 5. The ends of the solar cells 100 within the submodule 303 are connected to the busbar 305, and the busbar 305 connects multiple submodules 303 electrically in parallel or series. It is preferable that this configuration adjusts the output voltage with the second solar cell module 302. It should be noted that the connection form of the solar cells 100 shown in this fourth embodiment is just one example, and other connection forms can be used to construct a solar cell module.

### (FIFTH EMBODIMENT)

A fifth embodiment relates to a photovoltaic power generation system. In this fifth embodiment, the solar cell module can be used as a generator for power generation in the photovoltaic power generation system of this embodiment. The photovoltaic power generation system of this embodiment generates electricity using a solar cell module and specifically includes a solar cell module that generates electricity, unit for converting the generated electricity into power, unit for storing the generated electricity (an accumulator), or a load for consuming the generated electricity. FIG. 10 shows a configuration diagram of the photovoltaic power generation system 400 according to this embodiment. The photovoltaic power generation system shown in FIG. 10 comprises a solar cell module 401 (300), a converter 402, a storage cell 403, and a load 404. Either the storage cell 403 or the load 404 may be omitted. The load 404 may also be configured to utilize electrical energy stored in the storage cell 403. The converter 402 is a device that includes a circuit or element for performing power conversion, such as voltage transformation or DC-AC conversion, including a DC-DC converter, a DC-AC converter, an AC-AC converter, etc. The configuration of the converter 402 should be appropriately selected according to the generation voltage, the configurations of the storage cell 403 and the load 404.

Electricity generated by solar cells included in the submodules 303 receiving light in the solar cell module 401 is converted by the converter 402 and stored in the storage cell 403 or consumed by the load 404. The solar cell module 401 may be provided with a solar tracking drive device for always directing the solar cell module 401 towards the sun, or a concentrator for focusing sunlight to improve the power generation efficiency.

The photovoltaic power generation system 400 is preferably used in real estate such as residences, commercial facilities, and factories, or movable property such as vehicles, aircraft, and electronic devices. By using a highly efficient solar cell according to this embodiment in the solar cell module, an increase in power generation can be expected.

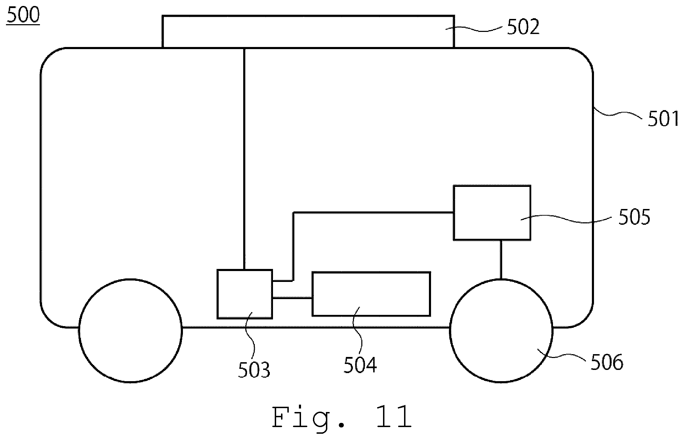

As an example of using the photovoltaic power generation system 400, a vehicle will be explained. FIG. 11 shows a conceptual diagram of the vehicle 500. The vehicle 500 shown in FIG. 11 includes a car body 501, a solar cell module 502, a power conversion device 503, a storage cell 504, a motor 505, and tires (wheels) 506. Electricity generated by the solar cell module 502 mounted on the top of the car body 501 is converted by the power conversion device 503 and charged into the storage cell 504 or consumed as power by a load such as the motor505. The vehicle 500 can be driven by rotating the tires (wheels) 506 with the motor 505 using electricity supplied from the solar cell module 502 or the accumulator 504. The solar cell module 502 may consist only of the first solar cell module equipped with the solar cell 100 according to the first embodiment, rather than a multi-junction type. When the transparent solar cell module 502 is adopted, it is also preferable to use the solar cell module 502 as a power generating window not only on the top of the car body 501 but also on the side of the car body 501.

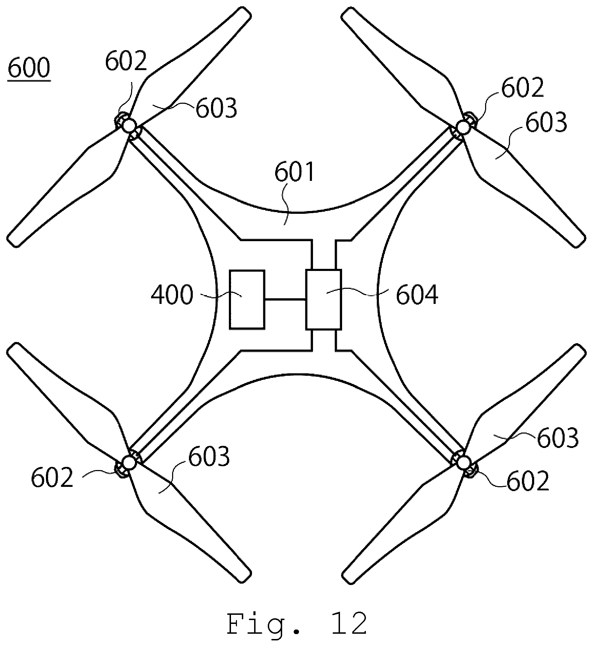

As an example of using the photovoltaic power generation system 400, a drone (quadcopter) will be explained. The drone uses the solar cell module 401. A simplified explanation of the configuration of the drone according to this embodiment will be given by referring to FIG. 12, a schematic diagram of the drone 600. The drone 600 comprises the solar cell module 401, a fuselage frame 601, a motor 602, a rotor 603, and a control unit 604. The solar cell module 401, the motor 602, the rotor 603, and the control unit 604 are arranged on the fuselage frame 601. The control unit 604 converts and adjusts the output power from the solar cell module 401. The motor 602 rotates the rotor 603 using the electricity supplied from the solar cell module 401. By adopting this configuration of the drone 600 with the solar cell module 401 according to this embodiment, it is possible to provide a drone capable of flying using more power.

Hereinafter, the present invention will be described in more detail with reference to examples, but the present invention is not limited to these examples.

### (EXAMPLE A)

### (Example A, Comparative Example)

ITO (In:Sn = 80:20, film thickness 150 [nm]) and ATO (Sn:Sb = 98:2, film thickness 100 [nm]) are deposited as the p-electrode 2 on a quartz glass substrate in direct contact with the glass. The p-type light absorbing layer 3 is formed on the ATO by a sputtering method in an atmosphere of nitrogen, oxygen and argon gas. The carrier concentration of the obtained laminate is measured, and the grain size is evaluated from the surface opposite to the p-electrode 2 side of the p-type light absorbing layer 3.

Non-contact evaluation is performed on the surface opposite to the p-electrode 2 side of the p-type light absorbing layer 3. Then, a cross-sectional view of the aforementioned analysis spot is obtained and the grain size is evaluated.

When the grain size (the first grain size) of the p-type light absorbing layer 3 is 0.1 times or more and less than 0.5 times the film thickness, the grain size is evaluated as D. When the grain size (the first grain size) of the p-type light absorbing layer 3 is 0.5 times or more and 1.2 times or less the film thickness, the grain size is evaluated as C. When the grain size (the first grain size) of the p-type light absorbing layer 3 is more than 1.2 times and less than 1.5 times the film thickness, the grain size is evaluated as B. When the grain size (the first grain size) of the p-type light absorbing layer 3 is more than 1.5 times and 10.0 times or less the film thickness, the grain size is evaluated as A.

When carrier concentration of the p-type light absorbing layer 3 is 1.0 × 10¹⁵ [cm⁻³] or more, the carrier concentration is evaluated as A. When carrier concentration of the p-type light absorbing layer 3 is less than 1.0 × 10¹⁵ [cm⁻³] and 8.0 × 10¹⁴ [cm⁻³] or more, the carrier concentration is evaluated as B. When carrier concentration of the p-type light absorbing layer 3 is less than 8.0 × 10¹⁴ [cm⁻³] and 5.0 × 10¹⁴ [cm⁻³] or more, the carrier concentration is evaluated as C. When carrier concentration of the p-type light absorbing layer 3 is less than 5.0 × 10¹⁴ [cm⁻³], the carrier concentration is evaluated as D.

When the mobility of the p-type light absorbing layer 3 is 20 [cm²/(V·s)] or more, the mobility is evaluated as A. When the mobility of the p-type light absorbing layer 3 is less than 20 [cm²/(V·s)] but 10 [cm²/(V·s)] or more, the mobility is evaluated as B. When the mobility of the p-type light absorbing layer 3 is less than 10 [cm²/(V·s)], the mobility is evaluated as C.

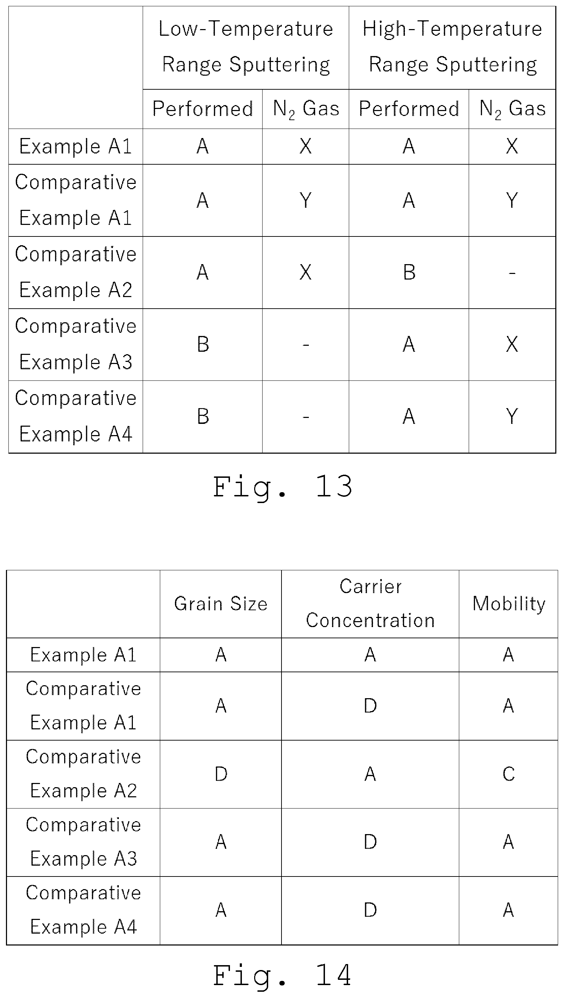

Table shown in FIG. 13 summarizes the manufacturing conditions of the laminated bodies of Example A1 (Example A) and Comparative Examples A1 to A3 (Comparative Example A). "A" indicates cases where low-temperature range sputtering and high-temperature range sputtering are performed, while "B" indicates cases where such sputtering is not performed. "X" indicates cases where N₂ gas is introduced into chamber 21 together with oxygen gas and argon during sputtering, while "Y" indicates cases where N₂ gas is not introduced. Example A1 obtains a laminated body by performing high-temperature range sputtering following low-temperature range sputtering. Comparative Example A1 obtains a laminated body through the same process as Example A1 except that sputtering is performed in an atmosphere without N₂ gas together with oxygen gas and argon gas during formation of the p-type light absorbing layer 3. Comparative Example A2 obtains a laminated body through the same process as Example A1 except that high-temperature range sputtering is not performed. Comparative Example A3 obtains a laminated body through the same process as Example A1 except that low-temperature range sputtering is not performed.

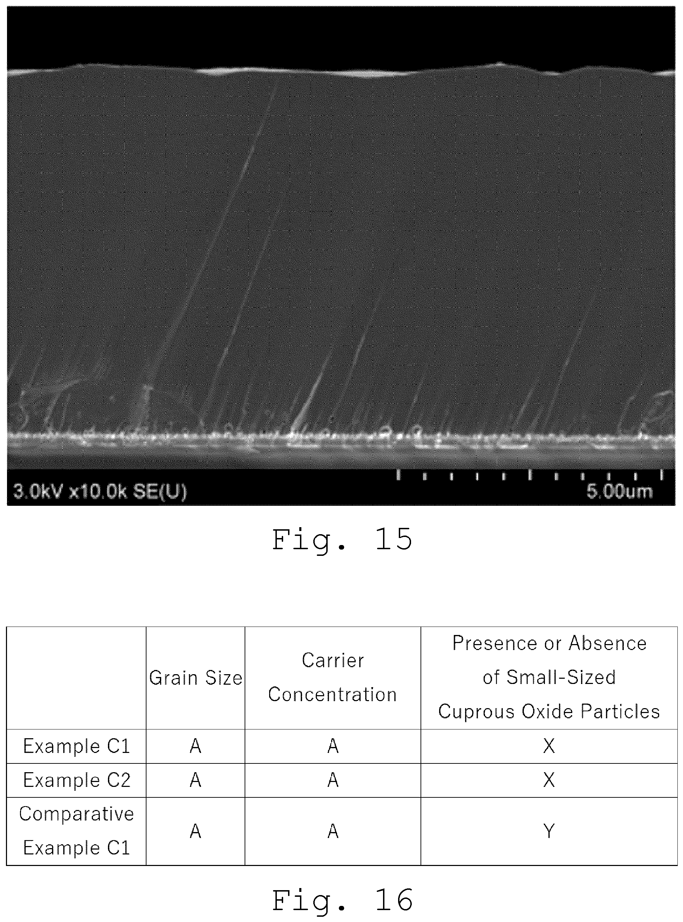

Table 14 shows the results of Example A. As shown in Table 14, the crystal growth of Example A1 which continuously introduced N₂ gas into chamber 21 during both low-temperature range sputtering and high-temperature range sputtering was good and its carrier concentration was high. FIG. 15 is a cross-sectional SEM image of Example A1. As can be seen from the cross section, it is clear that large crystals with diameters significantly larger than the film thickness are formed. The laminated body of Comparative Example A1 which performed low-temperature range sputtering and high-temperature range sputtering without introducing N2 gas into chamber 21 showed good crystal growth but its carrier concentration is lower than that of Example A1. The laminated body of Comparative Example A2 which do not perform high-temperature range sputtering has a high carrier concentration due to the introduction of N2 gas into chamber 21 during low-temperature range sputtering, but its crystal growth is insufficient. The laminated body of Comparative Example A3 which do not perform low-temperature range sputtering has a low carrier concentration even though N₂ gas is introduced into chamber 21 during the high-temperature range sputtering. The results show that performing both low-temperature range sputtering and high-temperature range sputtering consecutively, while introducing N₂ gas into chamber 21 at least during the low-temperature range sputtering, allows for both good crystal growth of the cuprous oxide compound and a high carrier concentration.

### (Example B)

As a reference example, Example B uses a laminate corresponding to Comparative Example A4 to obtain a solar cell, Reference Example B1, and evaluates its power generation characteristics. The carrier concentration obtained from the evaluation is changed for simulation to assess how the conversion efficiency of a solar cell with large grain size p-type light absorbing layer 3 improves with differences in carrier concentration.

### (Reference Example B1)

ITO (In:Sn = 80:20, film thickness 150 [nm]) and ATO (Sn:Sb = 98:2, film thickness 100 [nm]) are deposited as the p-electrode 2 on a quartz glass substrate in direct contact with the glass. A 6 [µm] thick film of the p-type light absorbing layer 3 is formed on the ATO by sputtering in an atmosphere of oxygen and argon gas. After forming the p-type light absorbing layer 3, a 11 [nm] thick Ga₂O₃ film is formed as the n-type layer 4 (first n-type layer). A 14 [nm] thick ZnSnO (Zn:Sn = 80:20) film is formed on the Ga₂O₃ as a second n-type layer. Then, a transparent electrode with Al added to Zn at 5% is formed by ALD with a thickness of 40 [nm] to obtain the solar cell 100. The first grain size of the cuprous oxide compound in the p-type light absorbing layer 3 is 1.2 times or more the thickness (6 µm) of the p-type light absorbing layer 3.

A solar simulator simulating AM1.5G light source is used, and the light intensity is adjusted to be 1 sun using a standard Si cell as a reference under the light source. Measurements are taken at atmospheric pressure with a room temperature of 25 [°C]. The voltage is swept, and the short-circuit current density Jsc (current divided by the cell area) is measured. The point where the horizontal axis intersects when plotting voltage on the horizontal axis and current density on the vertical axis becomes the open-circuit voltage Voc. On the measurement curve, the points where the product of voltage and short-circuit current density is maximized are defined as Vmpp and Jmpp (maximum power point), respectively. The fill factor FF is calculated from FF = (Vmpp × Jmpp) / (Voc × Jsc). The conversion efficiency Eff. is calculated from Eff. = Voc × Jsc × FF.

Using the obtained characteristics of the solar cell (the conversion efficiency = 10.5%, the carrier concentration of p-type light absorbing layer 3 = 2.0 × 10¹⁴ [cm⁻³], mobility = 100 [cm/(V·s)], the carrier concentration of n-type layer 4 = 6.0 × 10¹⁶ [cm⁻³]), the carrier concentration of the p-type light absorbing layer 3 is changed to 5.0 × 10¹⁴ (Example B1), 1.0 × 10¹⁵ (Example B2), 5.0 × 10¹⁵ (Example B3), 1.0 × 10¹⁶ (Example B4), and 5.0 × 10¹⁶ (Example B5) respectively, and simulations are performed to see how much the conversion efficiency changed. Simulations are performed using SCAPS (SCAPS-1D for thin film solar cells developed at ELIS, University of Gent) as simulation software, assuming an ohmic junction between the p-type light absorbing layer 3 and the p-electrode 2, and simulating a solar cell without the p-electrode 2.

The simulations showed that increasing the carrier concentration in the p-type light absorbing layer 3 effectively improved both FF and conversion efficiency compared to Reference Example B1 for Examples B1 to B5. Notably, FF and conversion efficiency significantly improved up to Example B2. In Examples B3 and B4, FF and conversion efficiency improved more gradually than in Example B2. There was little change in FF and conversion efficiency in Example B5 compared to Example B4. The simulation results can change when part of the model of the base solar cell is changed, but similar results were obtained for other solar cell models. Based on data from solar cells with large grain size p-type light absorbing layer 3, the simulation indicates that solarizing laminated body 10 of Example A1, which has a high carrier concentration and large grain size p-type light absorbing layer 3, can contribute to improving the conversion efficiency of the solar cell.

### (Example C)

### (Example C1)

ITO (In:Sn = 80:20, film thickness 150 [nm]) and ATO (Sn:Sb = 98:2, film thickness 100 [nm]) are deposited as the p-electrode 2 on a quartz glass substrate. A 6.6 [µm] thick film of the p-type light absorbing layer 3 is formed on the ATO by sputtering in an atmosphere of nitrogen, oxygen, and argon gas. The p-type light absorbing layer 3 is formed by low-temperature range sputtering followed by high-temperature range sputtering with a maintained supply of reaction gases, differing from Example A1 in temperature. The carrier concentration of the obtained laminated body 10 is measured, and the grain size is evaluated from the surface opposite to the p-electrode 2 side of the p-type light absorbing layer 3.

### (Example C2)

A laminated body 10 is obtained in the same manner as Example C1 except that the p-type light absorbing layer 3 is formed using a target with Cu as the main component and further including Si. The carrier concentration of the obtained laminated body 10 is measured, and the grain size is evaluated from the surface opposite to the p-electrode 2 side of the p-type light absorbing layer 3.

### (Comparative Example C1)

A laminated body 10 is obtained in the same manner as Example C1 except that a 0.5 [µm] thick cuprous oxide compound is formed by sputtering in a nitrogen, oxygen, and argon gas atmosphere at a low temperature range followed by stopping the reaction and sputtering a 6 [µm] thick cuprous oxide compound at a high-temperature range in an oxygen and argon gas atmosphere. The carrier concentration of the obtained laminated body 10 is measured, and the grain size is evaluated from the surface opposite to the p-electrode 2 side of the p-type light absorbing layer 3.

In Example C, carrier concentration and grain size are evaluated as in Example A. Further, the presence or absence of small-sized cuprous oxide particles is evaluated. The cross section of the laminated body 10 is observed by SEM, and when there are no particles with a diameter less than one-tenth of the film thickness on the p-electrode 2 side of the p-type light absorbing layer 3, it is rated as X. When particles with a diameter less than one-tenth of the film thickness exist on the p-electrode 2 side, it is rated as Y.

Table shown in FIG. 16 summarizes the evaluations of Example C. Both Examples C1 and C2, despite the difference in impurities being nitrogen and silicon, result in both crystal growth of cuprous oxide compounds and high carrier concentration. The laminated body 10 of Comparative Example C1 has both crystal growth of cuprous oxide compounds and a high carrier concentration because both low-temperature range sputtering and high-temperature range sputtering are performed; however, small-sized cuprous oxide particles are formed on the p-electrode 2 side, and large-sized cuprous oxide particles are in direct contact with the p-electrode 2 through these small-sized cuprous oxide particles.

In the specification, some elements are represented only by chemical symbols for elements.
layer mainly composed of[0182] While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A laminated body (10) comprising:
a transparent substrate (1);
a p-electrode (2) on the substrate (1), including a transparent conductive oxide film; and
a p-type light-absorbing layer (3) on the p-electrode (2), including a cuprous oxide compound, wherein
a crystal grain size of the cuprous oxide compound is 1.2 times or more a thickness of the p-type light-absorbing layer (3),
a carrier concentration of the p-type light-absorbing layer (3) is 5.0×10¹⁴ [cm⁻³] or more,
the cuprous oxide compound comprises Cu, oxygen, and optionally an element represented by M1, and
the element represented by M1 is one or more elements selected from the group consisting of Li, Na, K, Al, Ga, In, C, Si, Ge, Sn, N, P, Sb, and Bi.

2. The laminated body (10) according to claim 1, wherein
the element represented by M1 is Si or/and N.

3. The laminated body (10) according to claim 1 or 2, wherein
the carrier concentration of the p-type light-absorbing layer (3) is 1.0×10¹⁸ [cm⁻³] or less.

4. The laminated body (10) according to any one of claims 1 to 3, wherein
the thickness of the p-type light-absorbing layer (3) is 500 [nm] or more and 10 [µm] or less.

5. The laminated body (10) according to any one of claims 1 to 4, wherein
the mobility of the p-type light-absorbing layer (3) is 10 [cm²/(V·s)] or more.

6. The laminated body (10) according to any one of claims 1 to 5, wherein
when an atomic ratio of the copper element included in the p-type light-absorbing layer (3) is set to 100 [%],
a total amount of the element represented by M1 included in the p-type light-absorbing layer (3) is 0.00001 [%] or more and 1 [%] or less.

7. A solar cell (100) according comprising:
the laminated body (10) according to any one of claims 1 to 6;
an n-type layer (4) provided on the p-type light-absorbing layer (3) of the laminated body (10); and
an n-type electrode (5).

8. A multi-junction solar cell (200) comprising:
the solar cell (100) according to claim 7.

9. A manufacturing method for a laminated body (10) comprising:
forming a layer mainly composed of a cuprous oxide compound on a p-electrode (2) of the base member comprising a substrate (1) and the p-electrode (2) including a transparent conductive oxide film on the substrate (1), by sputtering using a target primarily composed of copper, wherein
the sputtering for the cuprous oxide compound is carried out continuously in a low-temperature range and then in a high-temperature range,
temperature of the base member during sputtering in the low-temperature range is 25 [°C] or more and 600 [°C] or less and is at least 50 [°C] lower than the maximum temperature in the high-temperature range, and
temperature of the base member during sputtering in the high-temperature range is more than 600 [°C] and 1000 [°C] or less.

10. The manufacturing method according to claim 9, wherein
the sputtering duration in the low-temperature range is 5% or more and 200% or less of the sputtering duration in the high-temperature range.

11. The manufacturing method according to claim 9 or 10, wherein
an average temperature of the base member during the low-temperature range sputtering is at least 100 [°C] lower than an average temperature of the base member during the high-temperature range sputtering.

12. The manufacturing method according to any one of claims 9 to 11, wherein
the minimum temperature of the base member during the low-temperature range sputtering is 550 [°C] or less.

13. The manufacturing method according to any one of claims 9 to 12, wherein
the minimum temperature of the base member during the low-temperature range sputtering is 450 [°C] or less.

14. The manufacturing method according to any one of claims 9 to 13, wherein
the copper element, oxygen, and the element represented by M1 are continuously supplied from the start of the sputtering reaction until the end of the sputtering process.

15. The manufacturing method according to any one of claims 9 to 14, wherein
an oxygen partial pressure in a chamber during sputtering is 0.01 [Pa] or more and 0.10 [Pa] or less.
